(19) **Europäisches Patentamt / European Patent Office / Office européen des brevets**

(11) **EP 4 708 698 A1**

(12) # EUROPEAN PATENT APPLICATION

(43) Date of publication:
**11.03.2026 Bulletin 2026/11**

(21) Application number: **25200433.8**

(22) Date of filing: **05.09.2025**

(51) International Patent Classification (IPC):
**H03M 1/12** $^{(2006.01)}$ **H03M 3/00** $^{(2006.01)}$

(52) Cooperative Patent Classification (CPC):
**H03M 1/123; H03M 3/43; H03M 3/458**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.09.2024 JP 2024155133**

(71) Applicant: **Canon Kabushiki Kaisha Tokyo, 146-8501 (JP)**

(72) Inventors:
• **FURUTA, Masanori**
  **Ohta-ku, Tokyo, 146-8501 (JP)**
• **ARISHIMA, Yu**
  **Ohta-ku, Tokyo, 146-8501 (JP)**

(74) Representative: **TBK**
  **Bavariaring 4-6**
  **80336 München (DE)**

(54) **AD CONVERSION CIRCUIT, PHOTOELECTRIC CONVERSION DEVICE, IMAGE CAPTURING DEVICE, AND MOBILE OBJECT**

(57) An ADC circuit is provided. The ADC circuit includes a continuous-time ΔΣ ADC including an integration circuit configured to integrate a difference signal, a switching circuit configured to perform switching to supply an analog signal supplied to an input terminal to the ΔΣ ADC in a first period and to supply a voltage signal corresponding to a voltage output from the integration circuit at an end of the first period in a second period after the first period, and a holding circuit configured to hold the voltage signal corresponding to the voltage output from the integration circuit at the end of the first period and provide the voltage signal to the ΔΣ ADC via the switching circuit in the second period. The ΔΣ ADC is configured to be able to perform gain adjustment for an analog signal input to the ΔΣ ADC.

**FIG. 3**

**Description**

TECHNICAL FIELD

The aspect of the embodiments relates to an AD conversion circuit, a photoelectric conversion device, an image capturing device, and a mobile object.

BACKGROUND

There is known an analog/digital converter (ADC) that converts an analog signal as a pixel output from a solid-state image capturing device into a digital signal. A $\Delta\Sigma$ ADC is known as an ADC. "S. Tao et. al., "A Power-Efficient Continuous-Time Incremental Sigma-Delta ADC for Neural Recording Systems", IEEE Transactions on Circuits and Systems I: Regular Papers (Volume: 62, Issue: 6, June 2015)" discloses a two-stage continuous-time $\Delta\Sigma$ ADC as a technique that speeds up a two-dimensional continuous-time $\Delta\Sigma$ ADC. This two-stage continuous-time $\Delta\Sigma$ ADC includes cascaded ADCs, one for performing AD conversion corresponding to an upper bit string and the other for performing AD conversion corresponding to a lower bit string upon receiving the residual voltage of the ADC corresponding to upper bits as an input.

SUMMARY

The two-stage continuous-time $\Delta\Sigma$ ADC is useful as a technique of increasing the A/D conversion speed while reducing the drive load on pixel output. On the other hand, this technique requires an ADC for performing A/D conversion corresponding to an upper bit string and an ADC for performing A/D conversion corresponding to a lower bit string and hence requires a large circuit packaging area.

The present disclosure in its first aspect provides an AD conversion circuit as specified in claim 1. Optional features are specified in claims 2 to 12.

The present disclosure in its second aspect provides a photoelectric conversion device as specified in claim 13.

The present disclosure in its third aspect provides an image capturing device as specified in claim 14.

The present disclosure in its fourth aspect provides a mobile object as specified in claim 15.

Features of the disclosure will become apparent from the following description of embodiments with reference to the attached drawings. The following description of embodiments is described by way of example.

BRIEF DESCRIPTION OF THE DRAWINGS

Fig. 1 is a block diagram showing an example of the arrangement of an AD conversion circuit according to the embodiment;

Fig. 2 is a block diagram showing an example of the arrangement of the AD conversion circuit according to the embodiment;

Fig. 3 is a block diagram showing an example of the arrangement of the AD conversion circuit according to the embodiment;

Fig. 4 is a timing chart showing the operation timing of the AD conversion circuit in Fig. 3;

Fig. 5 is a block diagram showing an example of the arrangement of the gain control circuit of the AD conversion circuit in Fig. 3;

Fig. 6 is a circuit diagram showing an example of the arrangement of the two-stage continuous-time $\Delta\Sigma$ AD converter of the AD conversion circuit in Fig. 3;

Fig. 7 is a circuit diagram showing another example of the integrator of the two-stage continuous-time $\Delta\Sigma$ AD converter in Fig. 6;

Fig. 8 is a circuit diagram showing an example of the arrangement of the two-stage continuous-time $\Delta\Sigma$ AD converter of the AD conversion circuit in Fig. 3;

Fig. 9 is a block diagram showing an example of the arrangement of the AD conversion circuit according to the embodiment;

Fig. 10 is a timing chart showing the operation timing of the AD conversion circuit in Fig. 9;

Fig. 11 is a block diagram showing an example of the arrangement of the gain control circuit of the AD conversion circuit in Fig. 9;

Fig. 12 is a circuit diagram showing an example of the arrangement of the variable amplification circuit of the AD conversion circuit in Fig. 9 and a buffer circuit having a voltage holding function;

Fig. 13 is a circuit diagram showing another example of the variable amplification circuit in Fig. 12;

Fig. 14 is a block diagram showing an example of the arrangement of the AD conversion circuit according to the embodiment;

Fig. 15 is a circuit diagram showing an example of the arrangement of the variable amplification circuit of the AD conversion circuit in Fig. 14;

Fig. 16 is a block diagram showing an example of the arrangement of the gain control circuit of the AD conversion circuit in Fig. 14;

Fig. 17 is a block diagram showing an example of the arrangement of the AD conversion circuit according to the embodiment;

Fig. 18 is a timing chart showing the operation timing of the AD conversion circuit in Fig. 17;

Fig. 19 is a circuit diagram showing another example of the variable amplification circuit in Fig. 15;

Fig. 20 is a circuit diagram showing another example of the variable amplification circuit in Fig. 15;

Fig. 21 is a block diagram showing an example of the arrangement of a photoelectric conversion device including the AD conversion circuit according to the embodiment;

Fig. 22 is a block diagram showing an example of the arrangement of a photoelectric conversion system including the AD conversion circuit according to the embodiment; and

Figs. 23A and 23B are views showing an example of the arrangement of a mobile object including the AD conversion circuit according to the embodiment.

DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

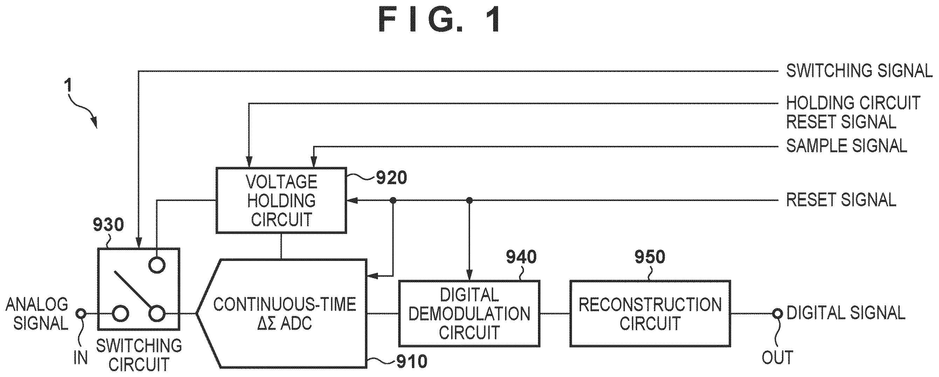

An AD conversion circuit according to an embodiment of the disclosure will be described with reference to Figs. 1 to 20. Fig. 1 shows the arrangement of an AD conversion circuit 1 according to the first embodiment of the disclosure. The AD conversion circuit 1 is configured as a two-stage continuous-time $\Delta\Sigma$ AD conversion circuit. The AD conversion circuit 1 converts the analog signal provided to an input terminal IN into a digital signal and outputs it from an output terminal OUT. The AD conversion circuit 1 can include a continuous-time $\Delta\Sigma$ AD converter 910 and a switching circuit 930. The AD conversion circuit 1 can also include a residual voltage holding circuit 920, a digital demodulation circuit 940, and a reconstruction circuit 950. The continuous-time $\Delta\Sigma$ AD converter 910 can include an integration circuit that integrates a difference signal. The switching circuit 930 supplies the analog signal supplied to the input terminal IN to the continuous-time $\Delta\Sigma$ AD converter 910. The switching circuit 930 supplies a voltage signal corresponding to the voltage output from the integration circuit of the continuous-time $\Delta\Sigma$ AD converter 910 at the end of the first period to the continuous-time $\Delta\Sigma$ AD converter 910 in the second period after the first period. The first period is a period in which A/D conversion is performed to generate an upper bit string of a digital signal corresponding to the analog signal provided to the input terminal IN. The second period is a period in which A/D conversion is performed to generate a lower bit string of a digital signal corresponding to the analog signal provided to the input terminal IN. The upper bit string can be constituted by a plurality of bits. The lower bit string can be constituted by a plurality of bits.

The residual voltage holding circuit 920 holds (samples) a voltage signal corresponding to the residual voltage output from the continuous-time $\Delta\Sigma$ AD converter 910 at the end of the first period and provides the voltage signal to the switching circuit 930 in the second period. The residual voltage holding circuit 920 can be controlled by, for example, a holding circuit reset signal and a sample signal.

In the first period, the continuous-time $\Delta\Sigma$ AD converter 910 performs A/D conversion corresponding to an upper bit string, and the switching circuit 930 supplies a voltage signal corresponding to the residual voltage held by the residual voltage holding circuit 920 at the end of the first period to the continuous-time $\Delta\Sigma$ AD converter 910. Subsequently, in the second period, the continuous-time $\Delta\Sigma$ AD converter 910 performs A/D conversion corresponding to a lower bit string. The digital demodulation circuit 940 demodulates the time-series $\Delta\Sigma$ modulated signal (upper bit string) output from the continuous-time $\Delta\Sigma$ AD converter 910 in the first period into a digital signal having a plurality of bits. In addition, the digital demodulation circuit 940 demodulates the time-series $\Delta\Sigma$ modulated signal (lower bit string) output from the continuous-time $\Delta\Sigma$ AD converter 910 in the second period into a digital signal having a plurality of bits. The reconstruction circuit 950 generates an output digital signal based on the digital signal of the upper bit string and the digital signal of the lower bit string, which are demodulated by the digital demodulation circuit 940. An internal signal in the continuous-time $\Delta\Sigma$ AD converter 910 and an internal signal in the digital demodulation circuit 940 are reset before the start of the first period and before the start of the second period in accordance with reset signals. This arrangement can implement the AD conversion circuit 1 as a two-stage continuous-time $\Delta\Sigma$ AD conversion circuit by using the single continuous-time $\Delta\Sigma$ AD converter 910 and the residual voltage holding circuit 920. That is, the circuit size of the continuous-time $\Delta\Sigma$ AD conversion circuit is reduced.

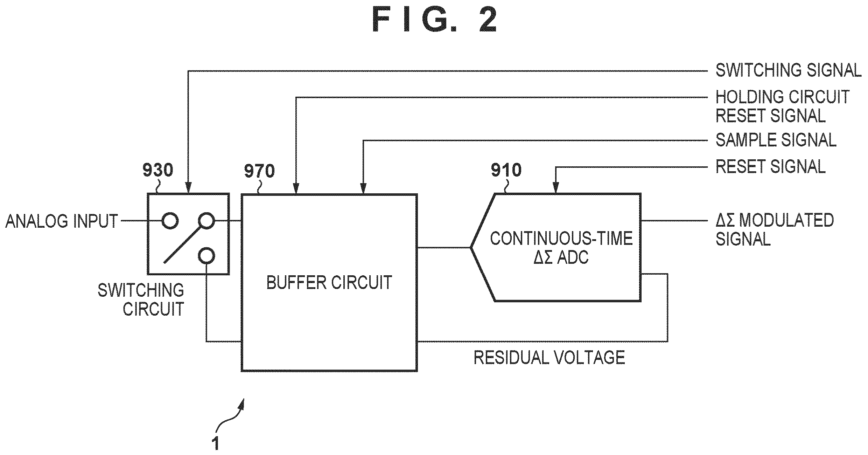

Fig. 2 is a block diagram showing a modification of the AD conversion circuit 1 shown in Fig. 1. In the AD conversion circuit 1 shown in Fig. 2, the residual voltage holding circuit 920 shown in Fig. 1 is replaced by a buffer circuit 970 having a residual voltage holding function. Referring to Fig. 2, a description of the digital demodulation circuit 940 and the reconstruction circuit 950 on the subsequent stage of the continuous-time $\Delta\Sigma$ AD converter 910 will be omitted.

The buffer circuit 970 having the residual voltage holding function can be controlled by, for example, a holding circuit reset signal and a sample signal. The buffer circuit 970 buffers an output from the switching circuit 930 and supplies it to the continuous-time $\Delta\Sigma$ AD converter 910. In the first period, while the continuous-time $\Delta\Sigma$ AD converter 910 performs A/D conversion corresponding to an upper bit string, the buffer circuit 970 buffers the analog input signal selected by the switching circuit 930 and supplies the signal to the continuous-time $\Delta\Sigma$ AD converter 910. Upon performing A/D conversion corresponding to the upper bit string, the buffer circuit 970 samples and holds the residual voltage output from the continuous-time $\Delta\Sigma$ AD converter 910 during or after A/D conversion corresponding to the upper bit string. Thereafter, the held residual voltage signal is input to the continuous-time $\Delta\Sigma$ AD converter 910 via the switching circuit 930 and the buffer circuit 970 having the residual voltage holding function and is subjected to A/D conversion corresponding to the lower bit string.

A voltage/current conversion circuit formed of a resistive element is generally used for input to the integrator in the continuous-time $\Delta\Sigma$ AD converter 910. Accordingly, a DC current corresponding to the voltage of an input analog signal flows in the voltage/current conversion circuit. If, for example, a source follower circuit is used as a circuit for supplying an analog signal to the continuous-time $\Delta\Sigma$ AD converter 910, a DC current corresponding to the analog signal voltage flows in addition to a bias current in the source follower circuit. Consequently, gain error occurs in the source follower circuit. This can cause a deterioration in the linearity of an input analog signal. As in the arrangement shown in Fig. 2, adding the buffer circuit 970 in the input path of an analog signal will suppress a DC current flowing in accordance with the voltage value of the analog signal input to the source follower circuit. This can improve the deterioration in the linearity of an input analog signal. In addition, sharing both the circuit for holding a residual voltage and the amplifier of the buffer circuit can improve the linearity without increasing the number of circuit elements or power.

The readout circuit of an image capturing device uses a $\Delta\Sigma$ AD converter to reduce the noise of the analog signal output from a pixel at low illuminance and improve the image quality without increasing the number of oversampling times by the AD converter. As a technique of implementing this requirement, Japanese Patent Laid-Open No. 2013-090234 discloses a solid-state image capturing device including a variable gain amplification circuit, on the preceding stage of the $\Delta\Sigma$ AD converter, which is capable of performing gain adjustment in accordance with an input amplitude. The analog signal amplification effect obtained by using the variable gain amplification circuit makes it possible to suppress noise in the $\Delta\Sigma$ AD converter as a subsequent-stage circuit and achieve low noise. However, adding an amplification circuit like that disclosed in Japanese Patent Laid-Open No. 2013-090234 can lead to an increase in the power consumption of the readout circuit.

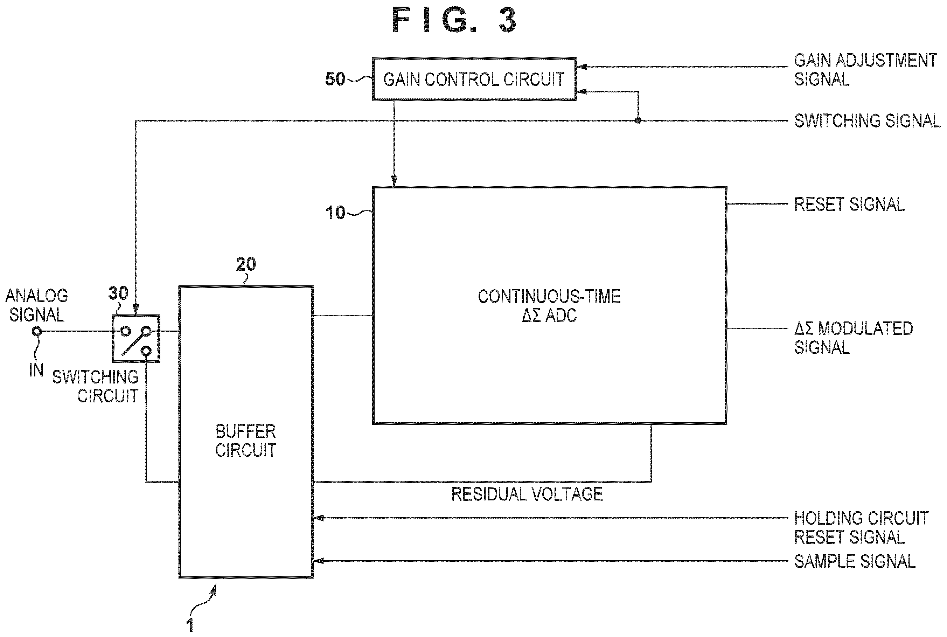

Fig. 3 is a block diagram showing an example of the arrangement of the AD conversion circuit 1 according to the embodiment. The AD conversion circuit 1 is configured as a two-stage continuous-time $\Delta\Sigma$ AD conversion circuit as in the case of the arrangement shown in Figs. 1 and 2. The AD conversion circuit 1 converts the analog signal provided to the input terminal IN into a digital signal and outputs it from the output terminal OUT. The AD conversion circuit 1 can include a continuous-time $\Delta\Sigma$ AD converter 10 having a gain adjustment function, a switching circuit 30, and a gain control circuit 50 as a control circuit that controls the gain adjustment function of the continuous-time $\Delta\Sigma$ AD converter 10. The AD conversion circuit 1 can also include a buffer circuit 20. In addition, the AD conversion circuit 1 can include the digital demodulation circuit 940 and the reconstruction circuit 950 on the subsequent stage of the continuous-time $\Delta\Sigma$ AD converter 10. However, illustrations of these components are omitted in Fig. 3. The arrangements of the buffer circuit 20 and the switching circuit 30 can be similar to those of the buffer circuit 970 and the switching circuit 930 described above.

The switching circuit 30 performs switching control between an input analog signal and an output signal from the buffer circuit 20 having the voltage holding function. The buffer circuit 20 receives the analog signal selected by the switching circuit 30 and outputs the buffered signal to the continuous-time $\Delta\Sigma$ AD converter 10. The continuous-time $\Delta\Sigma$ AD converter 10 performs A/D conversion corresponding to upper bits with respect to the buffered signal by using the set gain controlled by the gain control circuit 50. The switching control performed by the switching circuit 30 can be controlled in accordance with a switching signal.

The buffer circuit 20 having the voltage holding function samples and holds the residual voltage output from the continuous-time $\Delta\Sigma$ AD converter 10 during or after A/D conversion corresponding to the upper bit string. The buffer circuit 20 can be controlled by a holding circuit reset signal and a sample signal. The switching circuit 30 selects the residual voltage held by the buffer circuit 20 having the voltage holding function after the A/D conversion corresponding to the upper bit string and supplies the buffered signal to the continuous-time $\Delta\Sigma$ AD converter 10. Thereafter, the continuous-time $\Delta\Sigma$ AD converter 10 performs A/D conversion corresponding to the lower bit string in accordance with the set gain supplied from the gain control circuit 50.

The digital demodulation circuit 940 respectively demodulates the time-series $\Delta\Sigma$ modulated signals output in A/D conversion periods corresponding to the upper bit string and the lower bit string into multi-bit digital signals. The multi-bit demodulated signals are input to the reconstruction circuit 950 after the conversion of the upper bit string and the conversion of the lower bit string to obtain digital output signals. The internal signal in the continuous-time $\Delta\Sigma$ AD converter 10 and the held voltage of the buffer circuit 20 can be respectively reset before the start of the A/D conversion corresponding to the upper bit string and the start of the A/D conversion corresponding to the lower bit string by using reset signals.

In the AD conversion circuit 1 shown in Fig. 3, the continuous-time $\Delta\Sigma$ AD converter 10 executes the gain adjustment of an input analog signal. In other words, the continuous-time $\Delta\Sigma$ AD converter 10 is configured to be able to perform the gain adjustment of the analog signal input to the continuous-time $\Delta\Sigma$ AD converter 10. Performing gain adjustment in accordance with the signal amplitude of an input analog signal can reduce quantization errors in the continuous-time $\Delta\Sigma$ AD converter 10 with respect to the analog signal output from pixels at low illuminance. For example, let G be the set gain controlled by the gain control circuit 50 and $V_{qn\_ADC}$ be quantization noise in the continuous-time $\Delta\Sigma$ AD converter 10. In this case, input referred noise $V_{n\_in}$ on the assumption that the analog signal properly adjusted to match the maximum value of an input signal range in the continuous-time $\Delta\Sigma$ AD converter 10 is obtained by using equation (1):

$$V_{n\_in} = \sqrt{\left(\frac{V_{qn\_ADC}}{G}\right)^2} \cdots (1)$$

The arrangement shown in Fig. 3 eliminates the need of a variable gain amplification circuit required for Japanese Patent Laid-Open No. 2013-090234. This makes it possible to reduce the circuit size of the AD conversion circuit 1 and also reduce the power consumption.

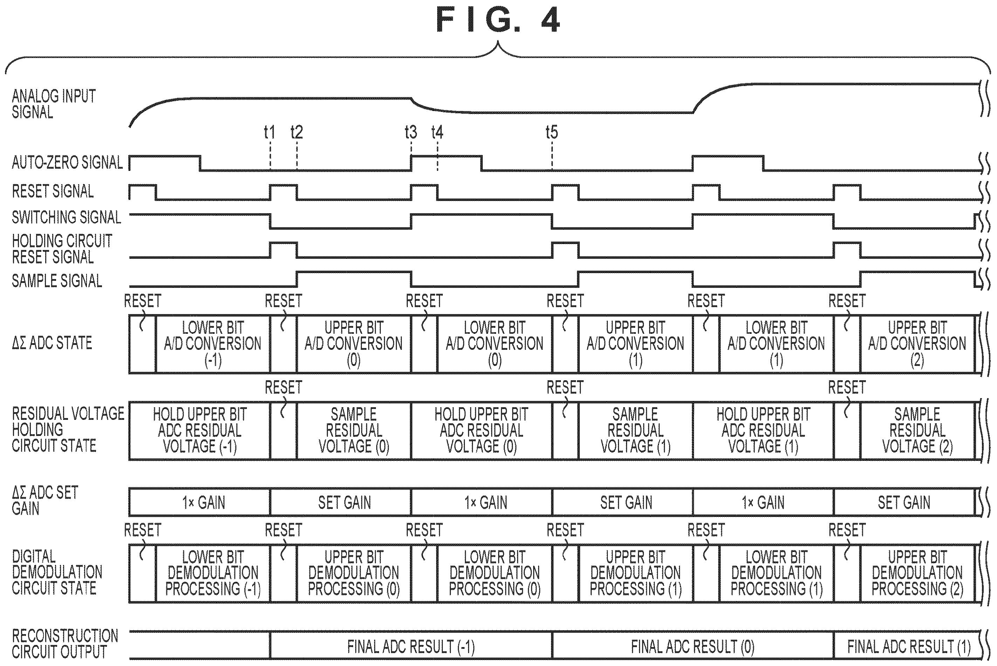

Fig. 4 shows the operation timing of the continuous-time $\Delta\Sigma$ AD converter 10 having the gain adjustment function shown in Fig. 2. As an example of the operation of the continuous-time $\Delta\Sigma$ AD converter 10, a processing procedure in which the reconstruction circuit 950 outputs the final ADC result (0) will be described.

In a period from time t1 to time t2, the reset signal is set to high level to reset the continuous-time $\Delta\Sigma$ AD converter 10 having the gain adjustment function and the digital demodulation circuit 940. At the same time, the holding circuit reset signal is set to high level to reset the buffer circuit 20 having the voltage holding function. At time t1, the switching signal is set to a low level to supply a buffered analog signal from the input terminal IN to the continuous-time $\Delta\Sigma$ AD converter 10 having the gain adjustment function via the buffer circuit 20. At time t2, from the time when the reset signal is set to low level, the continuous-time $\Delta\Sigma$ AD converter 10 starts A/D conversion corresponding to the upper bit string, and the buffer circuit 20 having the voltage holding function starts to sample a residual voltage. In addition, the digital demodulation circuit 940 starts demodulation processing of the upper bit string. At time t3, after the end of A/D conversion corresponding to the upper bit string, the buffer circuit 20 having the voltage holding function starts to hold the residual voltage of the continuous-time $\Delta\Sigma$ AD converter 10 having the gain adjustment function. At the same time, the reconstruction circuit 950 acquires a multi-bit modulated signal corresponding to the upper bit string. At time t3, the switching signal is set to high level to supply the buffered residual voltage to the continuous-time $\Delta\Sigma$ AD converter 10 having the gain adjustment function.

Subsequently, in a period from time t3 to time t4, the reset signal is set to high level to reset the continuous-time $\Delta\Sigma$ AD converter 10 having the gain adjustment function and the digital demodulation circuit 940. At time t4, from the time point when the reset signal is set to low level, the continuous-time $\Delta\Sigma$ AD converter 10 having the gain adjustment function starts A/D conversion corresponding to the lower bit string, and the digital demodulation circuit 940 starts demodulation processing of the lower bit string.

At time t5, after the end of A/D conversion corresponding to the lower bit string, the reconstruction circuit 950 acquires a multi-bit demodulated signal corresponding to the lower bit string. Subsequently, the reconstruction circuit 950 performs reconstruction processing by using the multi-bit demodulated signal corresponding to the upper bit string and the multi-bit demodulated signal corresponding to the lower bit string. With this operation, the final A/D conversion result corresponding to the digital output signal is output.

When the switching signal is at low level, the continuous-time $\Delta\Sigma$ AD converter 10 having the gain adjustment function performs $\Delta\Sigma$ A/D conversion with respect to the input signal having undergone gain adjustment in accordance with the set gain supplied from the gain control circuit 50. When the switching signal is at high level, the continuous-time $\Delta\Sigma$ AD converter 10 performs $\Delta\Sigma$ A/D conversion with respect to the input signal having undergone gain adjustment with 1x set gain. In other words, when the switching signal is at high level, the continuous-time $\Delta\Sigma$ AD converter 10 does not perform gain adjustment.

In a period in which A/D conversion corresponding to the upper bit string is performed, gain adjustment can be performed for the analog signal input to the continuous-time $\Delta\Sigma$ AD converter 10. In a period in which A/D conversion corresponding to the lower bit string is performed, gain adjustment need not be performed for the analog signal input to the continuous-time $\Delta\Sigma$ AD converter 10 (1x gain adjustment). For example, the set gain may be 2x, 4x, 8x, 16x, or the like. The analog signal input to the continuous-time $\Delta\Sigma$ AD converter 10 may not be amplified. The gain set by the gain control circuit 50 may be, for example, about 1x to 8x. However, limitation is not made thereto, and the gain set by the gain control circuit 50 may be equal to or less than 1x, for example, 0.5x.

The AD conversion circuit 1 performs A/D conversion with respect to an arbitrary input analog signal by repeatedly performing the above A/D conversion. In this case, it is assumed that an input analog signal in the above A/D conversion period corresponding to the upper bit string is constant.

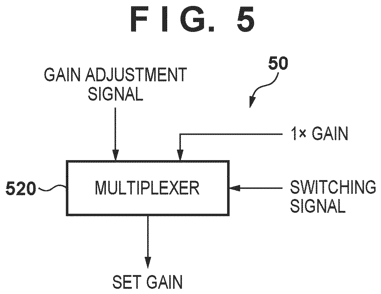

Fig. 5 shows an example of the arrangement of the gain control circuit 50. The gain control circuit 50 can include a multiplexer 520. The multiplexer 520 is controlled by a switching signal to select a gain adjustment signal and 1x gain. An output from the multiplexer 520 is input as a set gain to the continuous-time $\Delta\Sigma$ AD converter 10 having the gain adjustment function. The continuous-time $\Delta\Sigma$ AD converter 10 performs gain adjustment with respect to a supplied analog signal in accordance with the set gain.

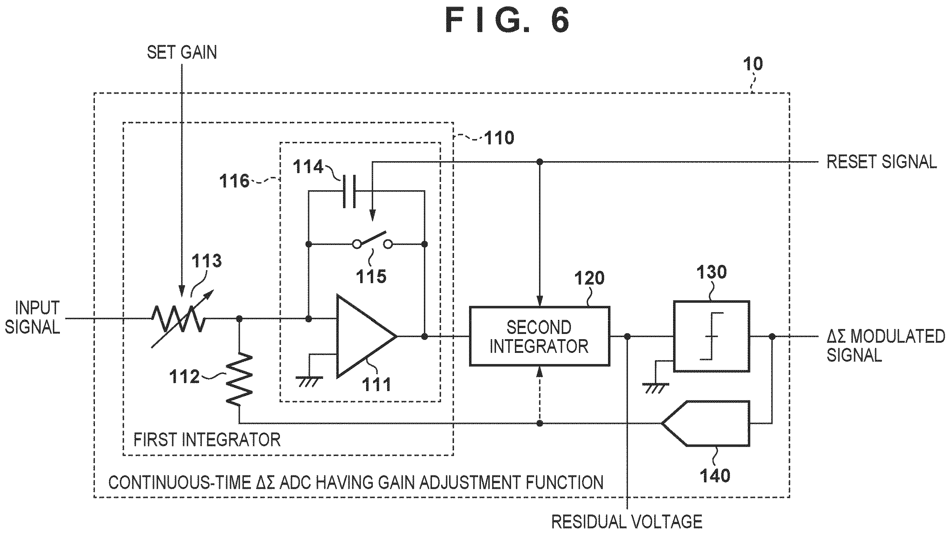

Fig. 6 shows an example of the arrangement of the continuous-time $\Delta\Sigma$ AD converter 10 having the gain adjustment function. The continuous-time $\Delta\Sigma$ AD converter 10 can be, for example, a second-order continuous-time $\Delta\Sigma$ AD converter. The continuous-time $\Delta\Sigma$ AD converter 10 includes, as integration circuits, a first integrator 110 and a second integrator 120 connected to the output of the first integrator 110. The continuous-time $\Delta\Sigma$ AD converter 10 also includes a comparator 130 that compares an output from the second integrator 120 with a reference signal and a DA converter 140 connected to the output of the comparator 130. The first integrator 110 includes a variable resistor 113 connected to the output of the switching circuit 30, an amplification circuit 116 connected to the output of the variable resistor 113, and a resistor 112 provided between the node between the variable resistor 113 and the amplification circuit 116 and the output of the DA converter 140. The amplification circuit 116 includes an amplifier 111, a capacitor 114, and a switch 115 which are connected in parallel with each other.

An output from the DA converter 140 is input to the first integrator 110 and the second integrator. An output from the second integrator 120 is output as the residual voltage of the continuous-time $\Delta\Sigma$ AD converter 10 having the gain adjustment function.

In the continuous-time $\Delta\Sigma$ AD converter 10 shown in Fig. 6, when the reset signal is at high level, the first integrator 110 and the second integrator 120 each are reset. For example, the first integrator 110 is reset by short-circuiting the capacitor 114 with the switch 115. When the reset signal is at low level, the first integrator 110 integrates the difference voltage between an input analog signal and an output from the DA converter 140. The variable resistor 113 is adjusted by the set gain supplied from the gain control circuit 50. Accordingly, ratio calculation between the resistor 112 and the variable resistor 113 is performed with respect to an input analog signal.

The second integrator 120 integrates the difference voltage between an output voltage from the first integrator 110 and an output from the DA converter 140. The comparator 130 performs a comparing operation for the difference voltage between an output voltage from the second integrator 120 and a reference voltage (for example, a ground voltage) by using a clock signal (not shown). The DA converter 140 outputs an analog voltage corresponding to an output signal from the comparator 130. The DA converter 140 can be configured so as to output an analog voltage corresponding to a 1-bit transfer function indicated by equation (2).

$$DACout(DACin) = \begin{cases} Vr, & (DACin = 1) \\ 0, & (DACin = 0) \end{cases} \cdots (2)$$

where DACin is an output signal from the comparator 130, Vr is a reference signal (not shown) in the continuous-time $\Delta\Sigma$ AD converter 10, and DACout is an output signal from the DA converter 140. The reference signal is 0. The second-order continuous-time $\Delta\Sigma$ AD converter 10 having the gain adjustment function shown in Fig. 6 repeatedly performs an integrating operation, a comparing operation, and digital/analog conversion in a period from when a reset signal is set to low level to when the reset signal is set to high level.

In the arrangement shown in Fig. 6, providing the variable resistor 113 in the first integrator 110 enables the continuous-time $\Delta\Sigma$ AD converter 10 to perform gain adjustment of the analog signal input to the continuous-time $\Delta\Sigma$ AD converter 10. The gain control circuit 50 is a control circuit that controls the adjustment amount of gain by controlling the resistance value of the variable resistor 113. In addition, in the arrangement shown in Fig. 6, the second integrator 120 may have the same arrangement as that of the first integrator 110. In this case, the resistance value of the variable resistor 113 provided in the second integrator 120 may be constant. In other words, the second integrator 120 may have an arrangement in which the variable resistor 113 of the first integrator 110 is a normal resistor.

In the arrangement shown in Fig. 6, the AD conversion circuit 1 is configured as a second-order continuous-time $\Delta\Sigma$ AD converter. In the example shown in Fig. 6, in the AD conversion circuit 1, both the comparator 130 and the DA converter 140 have 1-bit configurations. However, the comparator 130 and the DA converter 140 may have multi-bit configurations, and the resistors equivalent to the resistor 112 of the first integrator 110 and the resistor 112 of the second integrator 120 may be increased in accordance with the resolution of the DA converter 140 and connected in parallel. Making the comparator 130 and the DA converter 140 have multi-bit configurations makes it possible to speed up A/D conversion performed by the continuous-time $\Delta\Sigma$ AD converter 10. A third-order or higher order continuous-time $\Delta\Sigma$ AD converter may be configured by adding one or more integrators between the second integrator 120 and the comparator 130. Increasing the number of integrators can speed up A/D conversion performed by the continuous-time $\Delta\Sigma$ AD converter 10.

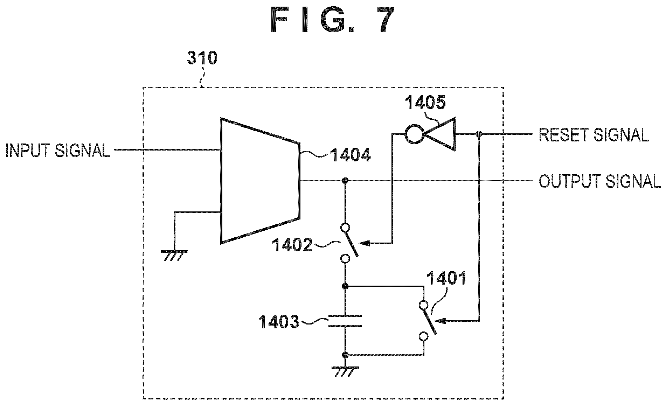

Fig. 7 shows a Gm-C integrator 310 as another example of the arrangement of the integrator in the continuous-time $\Delta\Sigma$ AD converter 10. The integrator 310 can include switches 1401 and 1402, a capacitor 1403, a transconductor 1404, and an inverter 1405. The switch 1401 is controlled by a reset signal. The switch 1402 is controlled by the reset signal inverted by the inverter 1405. When the reset signal is at high level, the capacitor 1403 is reset. When the reset signal is at low level, an integrating operation is performed by using the difference current between the current generated by the transconductor 1404 and an output signal current from a DA converter 190 and the capacitor 1403 in accordance with an input signal. If the Gm-C integrator 310 is used as the first integrator 110, the output of the DA converter 140 is connected to the output of the transconductor 1404. This arrangement can reduce the power consumption while implementing the same function as an integrator constituted by a resistor, a capacitor, and an amplifier. In addition, using a variable capacitor as the capacitor 1403 makes it possible to apply the Gm-C integrator 310 to the first integrator 110. That is, the first integrator 110 may be a Gm-C integrator including a transconductor and a variable capacitor. In this case, the gain control circuit 50 is a control circuit that controls the adjustment amount of gain by controlling the capacitance value of the capacitor 1403 as a variable capacitor.

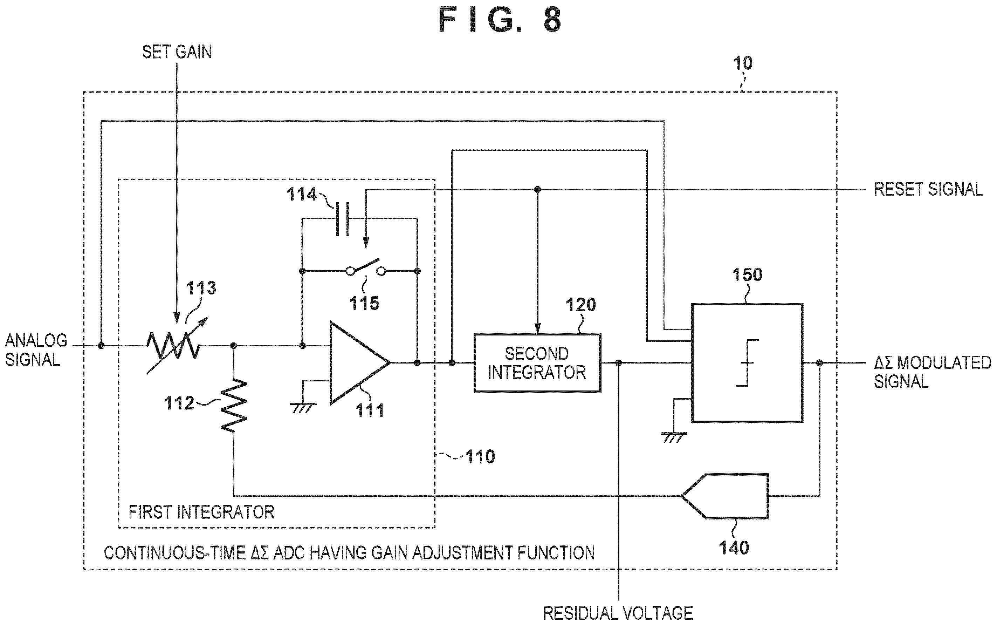

Fig. 8 shows another example of the arrangement of the continuous-time $\Delta\Sigma$ AD converter 10 having the gain adjustment function. The continuous-time $\Delta\Sigma$ AD converter 10 shown in Fig. 8 has a feedforward path. More specifically, the continuous-time $\Delta\Sigma$ AD converter 10 can include the first integrator 110, the second integrator 120, a 4-input comparator 150, and the DA converter 140. The first integrator 110 has, for example, an arrangement similar to that shown in Fig. 6. In the continuous-time $\Delta\Sigma$ AD converter 10 shown in Fig. 8, the comparator 150 compares outputs from the first integrator 110 and the second integrator 120 and the analog signal supplied to the first integrator 110 with a reference signal. With this arrangement, the continuous-time $\Delta\Sigma$ AD converter 10 has a feedforward mechanism. The continuous-time $\Delta\Sigma$ AD converter 10 having the feedforward path is implemented by connecting the analog signal input to the first integrator 110 to the comparator 150. In this arrangement, it is possible to suppress the output signal amplitudes of the first integrator 110 and the second integrator 120. Suppressing the nonlinear influences of the amplifier 111 in the first integrator and the amplifier in the second integrator can improve the nonlinear distortion characteristics of the continuous-time $\Delta\Sigma$ AD converter 10.

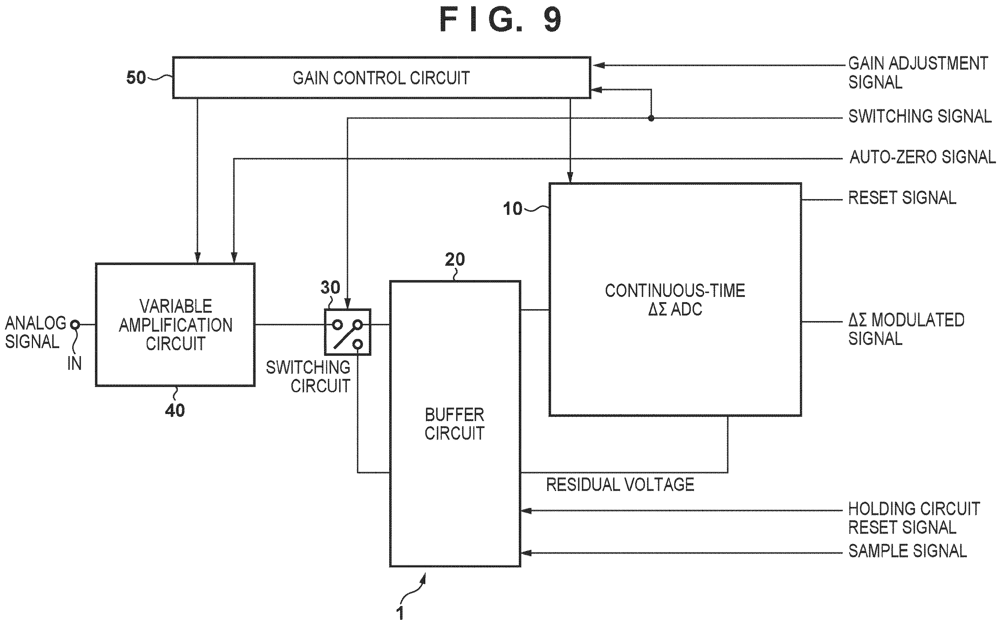

Fig. 9 is a block diagram showing a modification of the AD conversion circuit 1 shown in Fig. 3. The AD conversion circuit 1 shown in Fig. 9 further includes a variable amplification circuit 40 between the input terminal IN and the switching circuit 30 in addition to the arrangement shown in Fig. 3. Although the continuous-time $\Delta\Sigma$ AD converter 10 can include the digital demodulation circuit 940 and the reconstruction circuit 950 on the subsequent stage of the continuous-time $\Delta\Sigma$ AD converter 910, Fig. 9 omits the illustration of the corresponding arrangement.

The variable amplification circuit 40 amplifies the analog signal supplied to the variable amplification circuit 40 and outputs the amplified analog signal. The switching circuit 30 supplies the analog signal amplified by the variable amplification circuit 40 and an output signal from the buffer circuit 20 having the voltage holding function to the buffer circuit 20 upon switching between them. The analog signal selected by the switching circuit 30 is supplied to the buffer circuit 20, which then supplies the buffered signal to the continuous-time ΔΣ AD converter 10.

The continuous-time ΔΣ AD converter 10 performs A/D conversion corresponding to the upper bit string with respect to the signal amplified by the variable amplification circuit 40 and buffered by the buffer circuit 20 in accordance with the set gain of the gain control circuit 50. Switching control of the switching circuit 30 can be performed by a switching signal. During or after A/D conversion corresponding to the upper bit string, the buffer circuit 20 having the voltage holding function samples and holds the residual voltage output from the continuous-time ΔΣ AD converter 10. The buffer circuit 20 having the voltage holding function can be controlled by a holding circuit reset signal and a sample signal. After the A/D conversion corresponding to the upper bit string, the switching circuit 30 selects the residual voltage held by the buffer circuit 20 having the voltage holding function and supplies the voltage as a buffered signal to the continuous-time ΔΣ AD converter 10 through the buffer circuit 20. Thereafter, the continuous-time ΔΣ AD converter 10 performs A/D conversion corresponding to the lower bit string in accordance with the set gain of the gain control circuit 50. The digital demodulation circuit 940 demodulates the time-series ΔΣ modulated signals output in A/D conversion periods respectively corresponding to the upper bit string and the lower bit string into multi-bit digital signals. The multi-bit demodulated signals are supplied to the reconstruction circuit 950 after the conversion of the upper bit string and the conversion of the lower bit string, thereby obtaining digital output signals. The variable amplification circuit 40 performs a reset operation for an internal signal with an auto-zero signal. In addition, an internal signal in the continuous-time ΔΣ AD converter 10 and the held voltage of the buffer circuit 20 having the voltage holding function are respectively reset by using reset signals before the start of A/D conversion corresponding to the upper bit string and A/D conversion corresponding to the lower bit string.

With the arrangement shown in Fig. 9, the gain adjustment function for the analog signal input to the AD conversion circuit 1 can be implemented in the variable amplification circuit 40 and the continuous-time ΔΣ AD converter 10 in a distributed manner. In the arrangement configured to distribute the gain function as well, performing gain adjustment in accordance with an input signal amplitude can reduce the quantization errors in the continuous-time ΔΣ AD converter 10 with respect to a pixel output analog signal at low illuminance. In addition, the arrangement shown in Fig. 9 can suppress noise in the continuous-time ΔΣ AD converter 10 other than quantization noise. For example, let G1 be the set gain of the variable amplification circuit 40, G2 is the set gain of the two-stage continuous-time ΔΣ AD converter 10 having the gain adjustment function, $V_{n\_ADC}$ be a circuit noise voltage when the set gain of part of the variable amplification circuit 40 and the continuous-time ΔΣ AD converter 10 is 1x, and $V_{qn\_ADC}$ be quantization noise in the continuous-time ΔΣ AD converter 10. In this case, the input referred noise $V_{n\_in}$ on the assumption that the analog signal properly adjusted to match the maximum value of the input signal range in the continuous-time ΔΣ AD converter 10 is input is obtained by equation (3)

$$V_{n\_in} = \sqrt{\left(\frac{V_{n\_ADC}}{G1}\right)^2 + \left(\frac{V_{qn\_ADC}}{G1 \times G2}\right)^2} \cdots (3)$$

Distributing the gain setting for the analog signal output from a pixel or the like can reduce the maximum gain set value of the variable amplification circuit 40. This can reduce the power consumption as compared with the arrangement configured to perform gain adjustment in the single variable amplification circuit 40 or the continuous-time ΔΣ AD converter 10 having the gain adjustment function. In addition, part of circuit noise can be reduced. For example, the set gain in the variable amplification circuit 40 which is set by the gain control circuit 50 may be 2x, 4x, 8x, 16x, or the like as in the continuous-time ΔΣ AD converter 10. The set gain may be, for example, about 1x to 8x. However, limitation is not made thereto, and the gain set in the variable amplification circuit 40 by the gain control circuit 50 may be 1x or less, for example, 0.5x. The gain set in the variable amplification circuit 40 may be set to be large, for example, at the time of image capturing under a dark condition and set to be small at the time of image capturing under a bright condition.

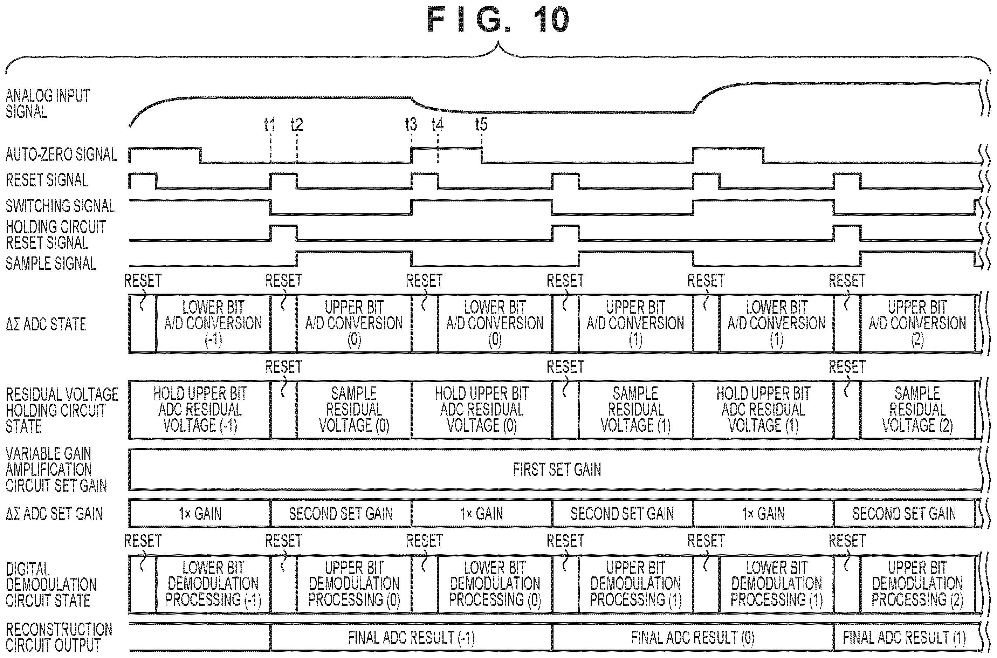

Fig. 10 is a timing chart showing the operation timing of the AD conversion circuit 1 including the continuous-time ΔΣ AD converter 10 having the gain adjustment function and the variable amplification circuit 40, which are shown in Fig. 9. The basic operation of the continuous-time ΔΣ AD converter 10 is the same as described above.

In a period from time t3 to time t5, the auto-zero signal is set to high level, and the variable amplification circuit 40 performs an auto-zero operation. In the interval from when the auto-zero signal is set to low level to when the next auto-zero signal is set to high level, the variable amplification circuit 40 performs signal amplification in accordance with the first set gain supplied from the gain control circuit 50. The time when the auto-zero signal is set to low level can be determined in consideration of the period in which an output voltage from the variable amplification circuit 40 completes a desired amplifying operation before the start of A/D conversion corresponding to the upper bit string by the continuous-time ΔΣ AD converter 10 having the gain adjustment function.

The continuous-time ΔΣ AD converter 10 having the gain adjustment function performs A/D conversion with respect to an input signal having undergone gain adjustment in accordance with the second set gain supplied from the gain control circuit 50 when the switching signal is at low level. While the switching signal is at high level, the continuous-time ΔΣ AD converter 10 performs A/D conversion with respect to an input signal having undergone gain adjustment with 1x set gain. The continuous-time ΔΣ AD converter 10 repeatedly performs above A/D conversion procedure to perform A/D conversion with respect to an analog signal having undergone arbitrary gain adjustment. In this case, it is assumed that the input analog signal during an A/D conversion period corresponding to the upper bit string is constant.

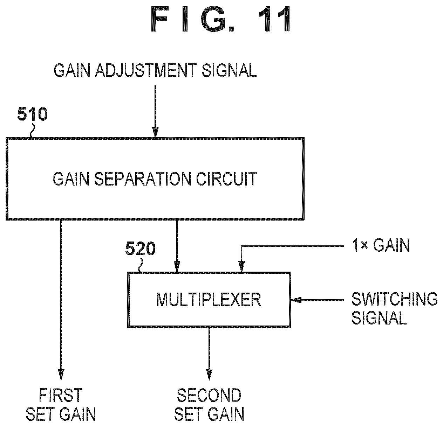

Fig. 11 shows an example of the arrangement of the gain control circuit 50 corresponding to the AD conversion circuit 1 shown in Fig. 9. The gain control circuit 50 can include a gain separation circuit 510 and the multiplexer 520. One output from the gain separation circuit 510 is supplied as the first set gain to the variable amplification circuit 40. The other output from the gain separation circuit 510 is supplied to the multiplexer 520. The multiplexer 520 is controlled by a switching signal to select an output from the gain separation circuit 510 and 1x gain. An output from the multiplexer 520 is supplied as the second set gain to the continuous-time ΔΣ AD converter 10 having the gain adjustment function.

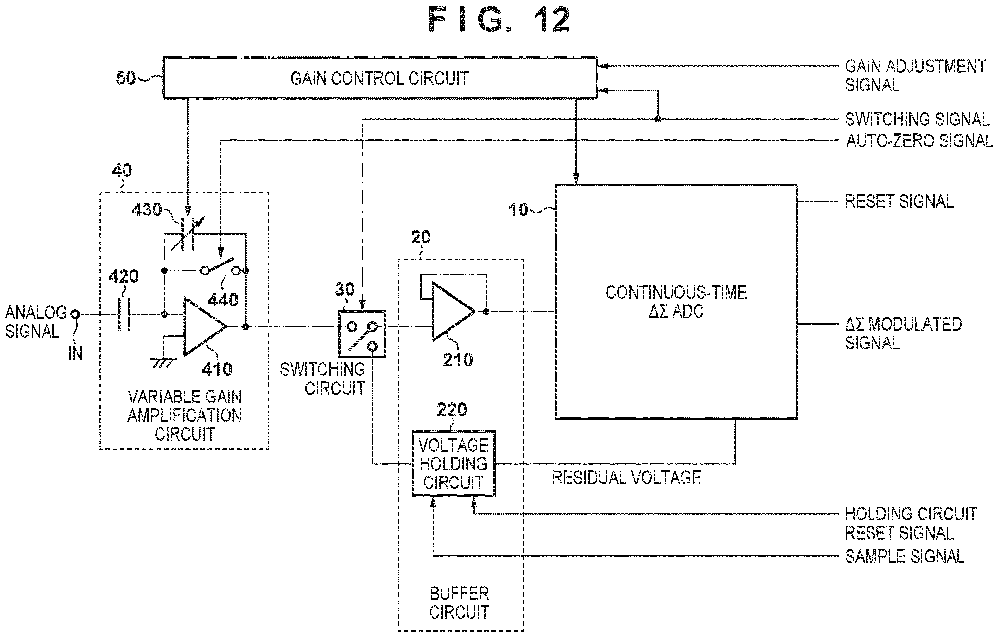

Fig. 12 is a circuit diagram showing an example of the arrangement of the variable amplification circuit 40 and the buffer circuit 20 having the voltage holding function. The variable amplification circuit 40 includes a capacitor 420, an amplifier 410 connected to the output of the capacitor 420 and arranged in parallel with each other, a switch 440, and a variable capacitor 430. In the variable amplification circuit 40, when the auto-zero signal is at high level, an input/output short circuit occurs in the amplifier 410, and the variable capacitor 430 is reset. In an auto-zero operation, the difference between an analog input signal and the voltage at the time of an input/output short circuit in the amplifier 410 is sampled by the capacitor 420. When the auto-zero signal is set to low level, the variable amplification circuit 40 performs an amplifying operation with respect to the difference voltage between an analog input signal in an auto-zero operation and an analog input signal in an amplifying operation. An amplification factor is determined by the ratio between the capacitor 420 and the variable capacitor 430 under the condition of finite DC gain of amplification circuit >> 1. The variable capacitor 430 is controlled in accordance with the first set gain supplied from the gain control circuit 50.

The buffer circuit 20 having the voltage holding function can include an amplifier 210 and a voltage holding circuit 220. The amplifier 210 is a circuit having a voltage follower configuration with one input being connected to the output. Under the condition of finite DC gain of amplification circuit >> 1, the amplifier 210 drives an input signal without attenuation. The voltage holding circuit 220 resets a held voltage when the holding circuit reset signal is set to high level. In a period in which the holding circuit reset signal is set to low level and the sample signal is at high level, the voltage holding circuit 220 samples a residual voltage. When the sample signal is set to low level, the voltage holding circuit 220 holds and outputs the sampled residual voltage.

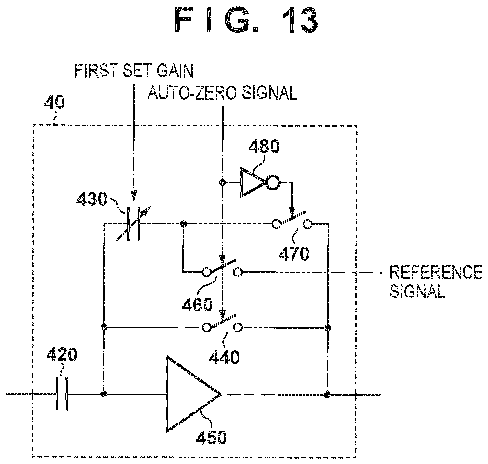

Fig. 13 shows another example of the arrangement of the variable amplification circuit 40. The variable amplification circuit 40 includes the capacitor 420, an amplifier 450 connected to the output of the capacitor 420 and arranged in parallel with each other, the switch 440, and the variable capacitor 430. The variable amplification circuit 40 also includes a switch 470 provided between the output of the variable capacitor 430 and the output of the amplifier 450, a switch 460 provided between the output of the variable capacitor 430 and a reference signal (internal reference voltage), and an inverter 408. The amplifier 450 forms a single-end amplifier. In the variable amplification circuit 40, when the auto-zero signal is at high level, an input/output short circuit occurs in the amplifier 450, and the variable capacitor 430 is reset by the voltage set at the time of short circuiting and a reference signal. In an auto-zero operation, the difference between an analog input signal and the voltage at the time of an input/output short circuit in the amplifier 450 is sampled by the capacitor 420. When the auto-zero signal is set to low level, the variable amplification circuit 40 performs an amplifying operation with respect to the difference voltage between an analog input signal in an auto-zero operation and an analog input signal in an amplifying operation. An amplification factor is determined by the ratio between the capacitor 420 and the variable capacitor 430 under the condition of finite DC gain of amplification circuit >> 1. In this case, the output voltage after amplification by the amplifier 450 oscillates about the reference signal. In this case, as in the case of the arrangement shown in Fig. 12, the variable capacitor 430 is controlled in accordance with the first set gain supplied from the gain control circuit 50. The variable amplification circuit 40 shown in Fig. 13 can reduce the power consumption as compared with the arrangement shown in Fig. 12 by using the single-end amplifier.

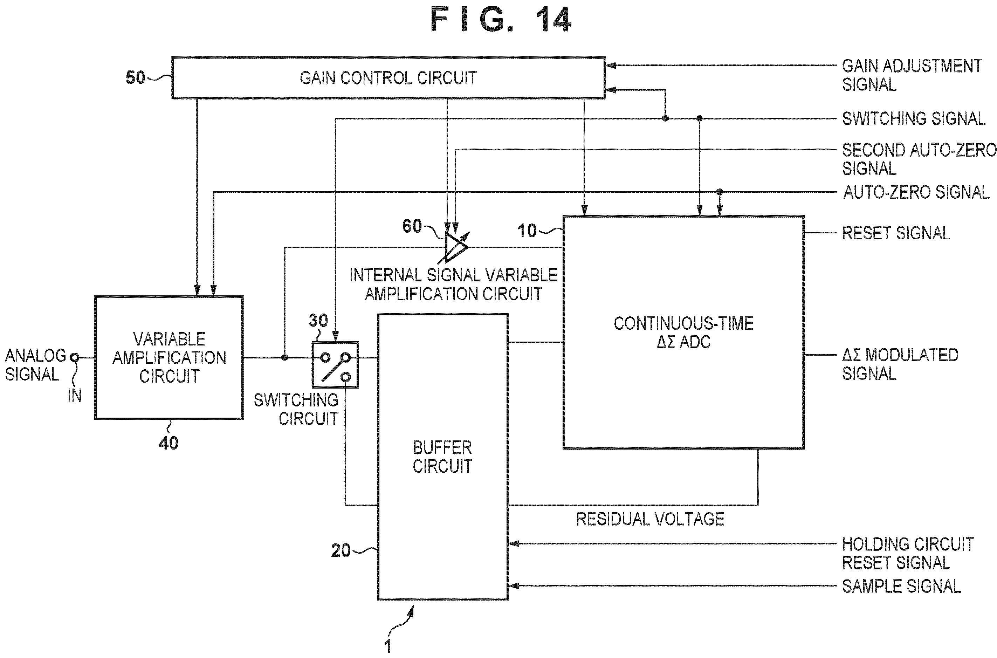

Fig. 14 shows the arrangement of an AD conversion circuit 1 according to the second embodiment of the disclosure. This arrangement is obtained by adding a variable amplification circuit 60 for internal signals to the arrangement shown in Fig. 9. The analog signal input from an input terminal IN to a switching circuit 30 is amplified. In addition, in the embodiment, a continuous-time ΔΣ AD converter 10 can be an AD converter having a feedforward path like that shown in Fig. 8.

A variable amplification circuit 40 performs gain adjustment with respect to an input analog signal in accordance with the gain setting supplied from the gain control circuit 50 and outputs, for example, an amplified analog signal. The switching circuit 30 performs switching control between the analog signal having undergone gain adjustment by the variable amplification circuit 40 and an output signal from the buffer circuit 20 having the voltage holding function. The buffer circuit 20 receives the analog signal selected by the switching circuit 30 and outputs the buffered analog signal. The variable amplification circuit 60 for internal signals performs gain adjustment with respect to the analog signal having undergone gain adjustment by the variable amplification circuit 40 in accordance with the gain setting supplied from a gain control circuit 50 and outputs an internal signal after gain adjustment. The continuous-time ΔΣ AD converter 10 having the gain adjustment function and the feedforward path performs A/D conversion corresponding to the upper bit string and the lower bit string with respect to the signal buffered by a buffer circuit 20 in accordance with the internal signal having undergone gain adjustment by the variable amplification circuit 60 and the gain setting supplied from the gain control circuit 50. Switching control on the switching circuit 30 is performed by a switching signal. As shown in Fig. 14, adding the variable amplification circuit 60 for internal signals to the above arrangement makes it possible to perform continuous-time ΔΣ A/D conversion in consideration of the gain adjustment of the feedforward path. Using a feedforward configuration as the continuous-time ΔΣ AD converter 10 can improve the nonlinear distortion characteristics regardless of the set gain of the variable amplification circuit 40.

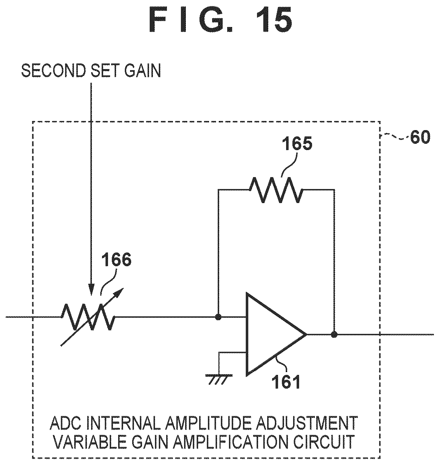

Fig. 15 shows an example of the arrangement of the variable amplification circuit 60 for internal signals. The variable amplification circuit 60 includes a variable resistor 166 and an amplifier 161 and a resistor 165 which are connected to the output of the variable resistor 166 and arranged in parallel with each other. The variable resistor 166 is connected to one input of the amplifier 161, and a reference signal is connected to the other input. The resistance value of the variable resistor 166 is switched in accordance with the second set gain supplied from the gain control circuit 50. The variable amplification circuit 60 outputs the voltage obtained by multiplying the difference between the analog signal input to the variable amplification circuit 60 and the reference signal by the ratio between the variable resistor 166 and the resistor 165.

As shown in Fig. 8, the continuous-time ΔΣ AD converter 10 having the feedforward path compares an output from a first integrator 110, an output from a second integrator 120, and the analog signal supplied to the first integrator 110 with the reference signal. The variable amplification circuit 60 for internal signals is provided in the path for the supply of the analog signal supplied to the first integrator 110 to a comparator 150. Accordingly, the comparator 150 compares an output from the first integrator 110, an output from the second integrator 120, and an output from the variable amplification circuit 60 with the reference signal. For example, in a period in which the analog signal input to the continuous-time ΔΣ AD converter 10 undergoes gain adjustment, the variable amplification circuit 60 may amplify the analog signal input to the comparator 150 shown in Fig. 8. In addition, for example, in a period (a period of 1x gain) in which the analog signal input to the continuous-time ΔΣ AD converter 10 undergoes no gain adjustment, the variable amplification circuit 60 may not amplify the analog signal. The variable amplification circuit 60 may perform gain adjustment with an arrangement in which a variable resistor is connected between an input and the output of the amplifier 161, and a fixed resistor is connected between the amplifier 161 and an input of the variable amplification circuit 60.

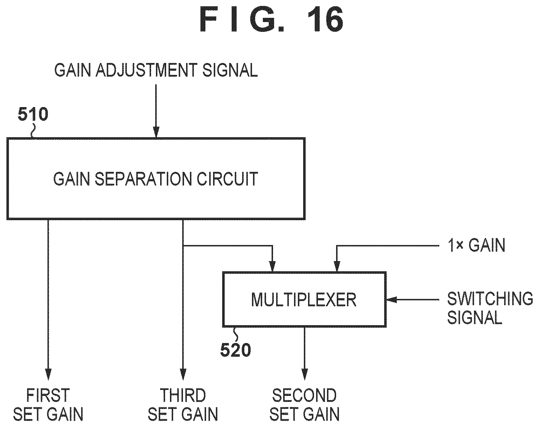

Fig. 16 shows an example of the arrangement of the gain control circuit 50 corresponding to the AD conversion circuit 1 shown in Fig. 14. The gain control circuit 50 can include a gain separation circuit 510 and a multiplexer 520. One output from the gain separation circuit 510 is supplied as the first set gain to the variable amplification circuit 40, and the other output is input to the multiplexer 520 and supplied as the third set gain to the variable amplification circuit 60 for internal signals. The multiplexer 520 is controlled by a switching signal to select a gain separation circuit output and 1x gain. The second set gain as an output from the multiplexer 520 is supplied to the continuous-time ΔΣ AD converter 10 having the gain adjustment function and the feedforward path.

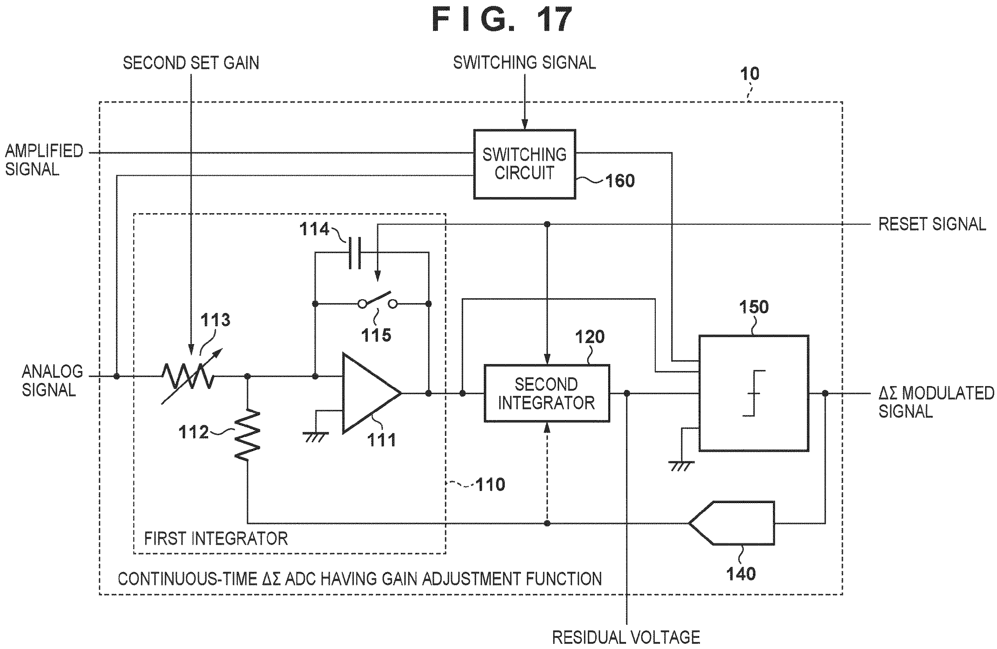

Fig. 17 shows another example of the arrangement of the continuous-time ΔΣ AD converter 10 having the gain adjustment function and the feedforward path. The arrangement shown in Fig. 17 includes a switching circuit 160 different from the switching circuit 30 in the arrangement shown in Fig. 8. The switching circuit 160 supplies an output from the variable amplification circuit 60 for amplifying the analog signal input from the input terminal IN to the switching circuit 30 and the analog signal input to the first integrator 110 to the comparator 150 upon switching between them. Other components may be similar to those in the arrangement shown in Fig. 8 described above, and hence a description of similar components will be omitted hereinafter.

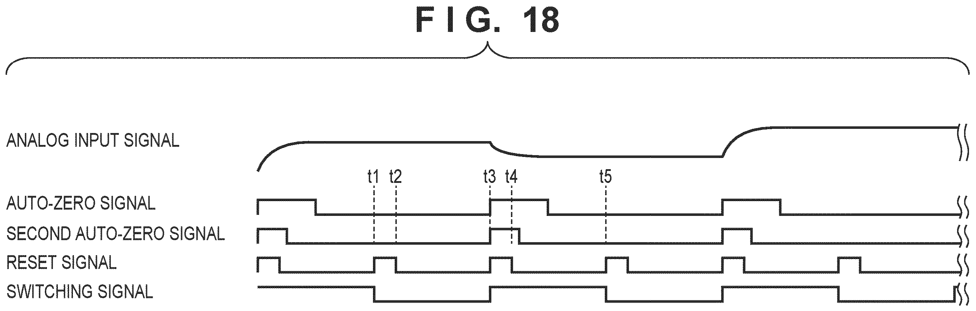

Fig. 18 is a timing chart showing an example of the operation of the AD conversion circuit 1 having the continuous-time ΔΣ AD converter 10 shown in Fig. 17. The variable amplification circuit 60 for internal signals performs an auto-zero operation by using the second auto-zero signal. The time when the second auto-zero signal is set to high level is the same time as the auto-zero signal. In contrast to this, the time when the second auto-zero signal is set to low level is set to be later than the time when the reset signal is set to low level and earlier than the time when the auto-zero signal is set to low level. That is, the auto-zero period of the variable amplification circuit 60 is set to be shorter than the auto-zero period of the variable amplification circuit 40, and the variable amplification circuit 60 amplifies the analog signal in accordance with the third set gain supplied from the gain control circuit 50 after the auto-zero operation of the variable amplification circuit 40. The amplified analog signal is used in the comparing operation of the 4-input comparator 150 in a period in which A/D conversion corresponding to the upper bit string is performed. That is, the comparator 150 compares an output from the first integrator 110, an output from the second integrator 120, and an output from the switching circuit 160 with the reference signal. In this case, the switching circuit 160 can supply an output from the variable amplification circuit 60 to the comparator 150 in a period in which gain adjustment is performed for the analog signal input to the continuous-time ΔΣ AD converter 10. On the other hand, the switching circuit 160 can supply the analog signal input to the first integrator 110 to the comparator 150 in a period in which no gain adjustment is performed for the analog signal input to the continuous-time ΔΣ AD converter 10.

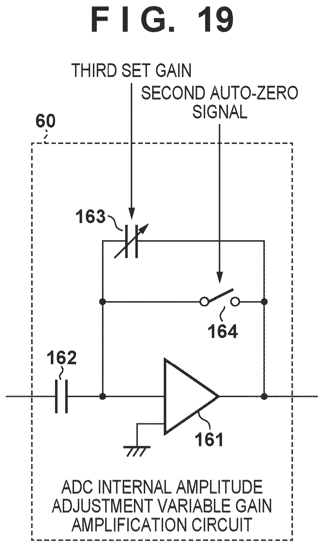

Fig. 19 shows another example of the arrangement of the variable amplification circuit 60 for internal signals. The variable amplification circuit 60 can include a capacitor 162, an amplifier 161 connected to the output of the capacitor 162 and arranged in parallel with each other, a switch 164, and a variable capacitor 163. In the variable amplification circuit 60 shown in Fig. 19, when the second auto-zero signal is set to high level, the amplifier 161 undergoes an input/output short circuit and is reset. In an auto-zero operation, the capacitor 162 samples the difference between an output signal from the variable amplification circuit 40 and the voltage set at the time of an input/output short circuit in the amplifier 161. When the second auto-zero signal is set to low level, the variable amplification circuit 60 performs an amplifying operation with respect to the difference voltage between an analog signal input in an auto-zero operation and an analog signal input in an amplifying operation. An amplification factor is determined by the ratio between the capacitor 162 and the variable capacitor 163 under the condition of finite DC gain of amplification circuit >> 1. The variable capacitor 163 is controlled in accordance with the third set gain supplied from the gain control circuit 50.

In the circuit arrangement shown in Fig. 15, which performs gain adjustment based on a resistance ratio, a DC current keeps flowing in the resistor of the input portion regardless of the operation state of the circuit. In contrast to this, in the circuit arrangement shown in Fig. 19, almost no DC current flows to the capacitor 162 after the completion of a desired amplifying operation. This improves the nonlinear distortion characteristics of the continuous-time $\Delta\Sigma$ AD converter 10 shown in Fig. 14 and reduces the power consumption of the variable amplification circuit 60 for internal signals as compared with the circuit arrangement shown in Fig. 15.

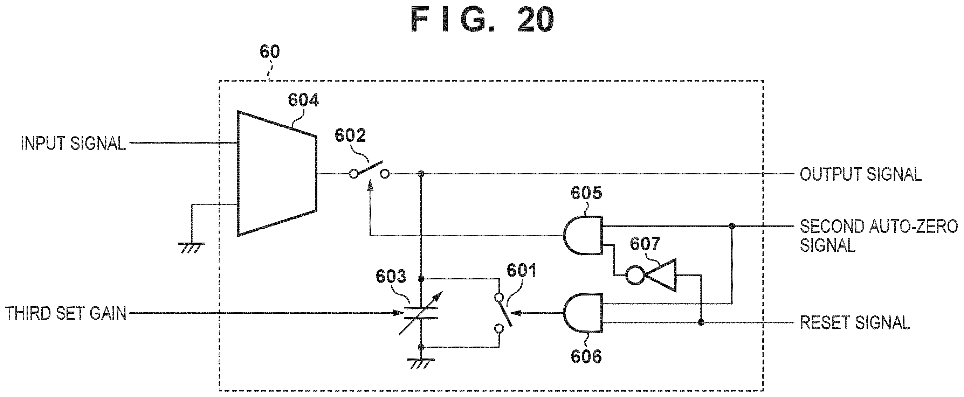

Fig. 20 shows another example of the arrangement of the variable amplification circuit 60 for internal signals. The variable amplification circuit 60 shown in Fig. 20 can include a transconductor 604 and a variable capacitor 603 connected to the output node of the transconductor 604. The variable amplification circuit 60 can include switches 601 and 602, AND gates 605 and 606, and an inverter 607. The switch 602 is connected between the variable capacitor 603 and the transconductor 604. The switch 601 is arranged in parallel to the variable capacitor 603. One end of the variable capacitor 603 is connected to a reference signal. The second auto-zero signal and the reset signal are supplied to the AND gate 606. An output from the AND gate 606 is used as a control signal for the switch 601. The second auto-zero signal and the reset signal via the inverter 607 are supplied to the AND gate 605. An output from the AND gate 605 is used as a control signal for the switch 602. The capacitance value of the variable capacitor 603 is controlled in accordance with the third set gain supplied from the gain control circuit 50.

When the second auto-zero signal is set to high level and the reset signal is set to high level, the variable amplification circuit 60 shown in Fig. 20 resets the variable capacitor 603. When the second auto-zero signal is set to high level and the reset signal is set to low level, a current corresponding to the difference voltage between an input signal and a reference signal flows from the transconductor 604 to the variable capacitor 603, thereby accumulating electric charge. Electric charge is accumulated during a period in which the second auto-zero signal is at high level, and a voltage corresponding to the accumulated electric charge becomes an output signal. The voltage of the output signal can be adjusted by the value of the variable capacitor.

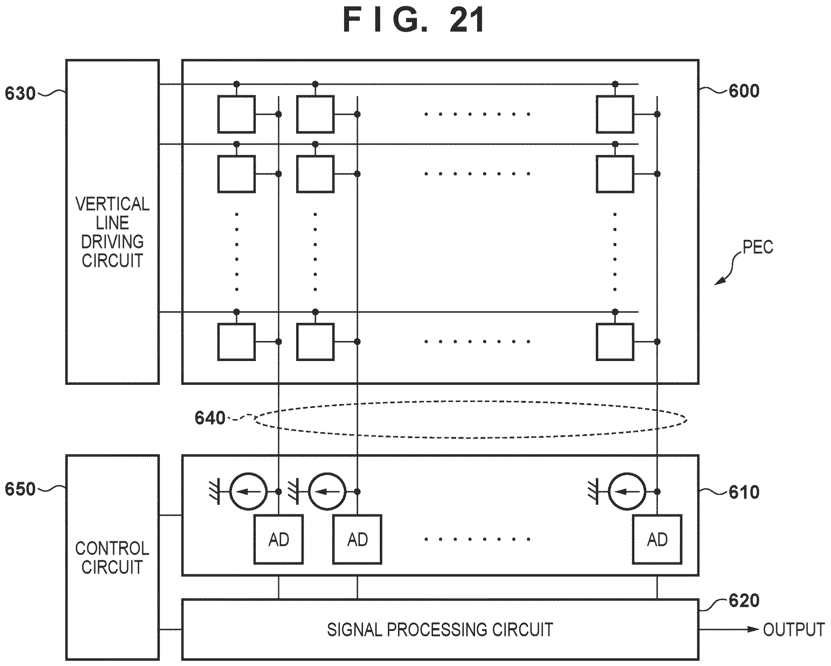

An application example of the AD conversion circuit 1 described above will be described below. Fig. 21 shows the arrangement of a photoelectric conversion device PEC using the AD conversion circuit 1 according to the disclosure. The photoelectric conversion device PEC can be configured as a solid-state image capturing device that captures and outputs an image. Alternatively, the photoelectric conversion device PEC can be configured as a device that captures an image and outputs a signal obtained from the captured image.

The photoelectric conversion device PEC can include, for example, a pixel array (an array of a plurality of photoelectric conversion units) 600, a vertical drive circuit 630, a readout circuit (a current source and an AC conversion circuit) 610, a control circuit 650, and a signal processing circuit 620. The readout circuit 610 can include a plurality of current sources respectively connected to a plurality of vertical lines 640 and an AD conversion circuit that A/D-converts signals output from pixels on a selected row to the plurality of vertical lines 640. The above two-stage continuous-time $\Delta\Sigma$ AD conversion circuit (AD conversion circuit 1) can be applied to each AD conversion circuit of the readout circuit 610. This makes it possible to reduce the size of the readout circuit 610.

The photoelectric conversion device PEC can be configured to make the readout circuit 610 read out a reset level from each pixel of the pixel array 600 and the optical signal level generated by photoelectric conversion. The readout circuit 610 can be configured to output a digital signal at the reset level and a digital signal at the optical signal level. The signal processing circuit 620 can be configured to perform CDS processing with respect to the digital signal at the reset level and the digital signal at the optical signal level and output the signals having undergone the CDS processing. The pixel array 600, the vertical drive circuit 630, the readout circuit 610, the control circuit 650, and the signal processing circuit 620 may be formed on one substrate, may be stacked on each other upon being respectively formed on a plurality of substrates, or may be separately formed on a plurality of chips. The photoelectric conversion device PEC can be a CMOS image sensor. Alternatively, the photoelectric conversion device PEC may be a front-illuminated sensor or back-illuminated sensor.

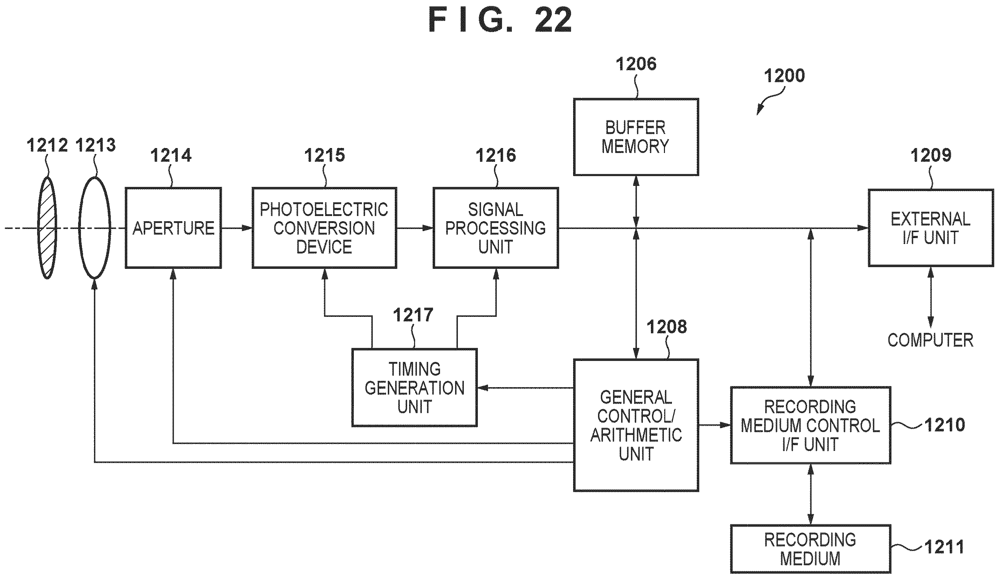

An example of a photoelectric conversion system using the photoelectric conversion device PEC will be described below. Fig. 22 is a block diagram showing the arrangement of a photoelectric conversion system 1200 according to an embodiment. The photoelectric conversion system 1200 according to the embodiment includes a photoelectric conversion device 1215. In this case, the photoelectric conversion device PEC described above can be applied as the photoelectric conversion device 1215. The photoelectric conversion system 1200 can be used as, for example, an image capturing system. Specific examples of the image capturing system are a digital still camera, a digital camcorder, and a monitoring camera. Fig. 22 shows an example of the digital still camera (image capturing device) as the photoelectric conversion system 1200.

The photoelectric conversion system 1200 shown in Fig. 22 includes the photoelectric conversion device 1215, a lens 1213 for forming an optical image of an object on the photoelectric conversion device 1215, an aperture 1214 for changing the amount of light passing through the lens 1213, and a barrier 1212 for protecting the lens 1213. The lens 1213 and the aperture 1214 form an optical system for concentrating light to the photoelectric conversion device 1215. The photoelectric conversion system used for image capturing is also called an image capturing system.

The photoelectric conversion system 1200 includes a signal processor 1216 for processing an output signal output from the photoelectric conversion device 1215. The signal processor 1216 performs an operation of signal processing of performing various kinds of correction and compression for an input signal, as needed, thereby outputting the resultant signal. The photoelectric conversion system 1200 further includes a buffer memory unit 1206 for temporarily storing image data and an external interface unit (external I/F unit) 1209 for communicating with an external computer or the like. Furthermore, the photoelectric conversion system 1200 includes a recording medium 1211 such as a semiconductor memory for recording or reading out image capturing data, and a recording medium control interface unit (recording medium control I/F unit) 1210 for performing a recording or reading operation in or from the recording medium 1211. The recording medium 1211 may be incorporated in the photoelectric conversion system 1200 or may be detachable. In addition, communication with the recording medium 1211 from the recording medium control I/F unit 1210 or communication from the external I/F unit 1209 may be performed wirelessly.

Furthermore, the photoelectric conversion system 1200 includes a general control/arithmetic unit 1208 that performs various kinds of arithmetic operations and controls the entire digital still camera, and a timing generation unit 1217 that outputs various kinds of timing signals to the photoelectric conversion device 1215 and the signal processor 1216. Here, the timing signal and the like may be input from the outside, and, in one embodiment, the photoelectric conversion system 1200 need only include at least the photoelectric conversion device 1215 and the signal processor 1216 that processes an output signal output from the photoelectric conversion device 1215. The timing generation unit 1217 may be incorporated in the photoelectric conversion device. The general control/arithmetic unit 1208 and the timing generation unit 1217 may be configured to perform some or all of the control functions of the photoelectric conversion device 1215.

The photoelectric conversion device 1215 outputs an image signal to the signal processor 1216. The signal processor 1216 performs predetermined signal processing for the image signal output from the photoelectric conversion device 1215 and outputs image data. The signal processor 1216 also generates an image using the image signal. Furthermore, the signal processor 1216 may perform distance measurement calculation for the signal output from the photoelectric conversion device 1215. Note that the signal processor 1216 and the timing generation unit 1217 may be incorporated in the photoelectric conversion device. That is, each of the signal processor 1216 and the timing generation unit 1217 may be provided on a substrate on which pixels are arranged or may be provided on another substrate. An image capturing system capable of acquiring a higher-quality image can be implemented by forming an image capturing system using the photoelectric conversion device of each of the above-described embodiments.

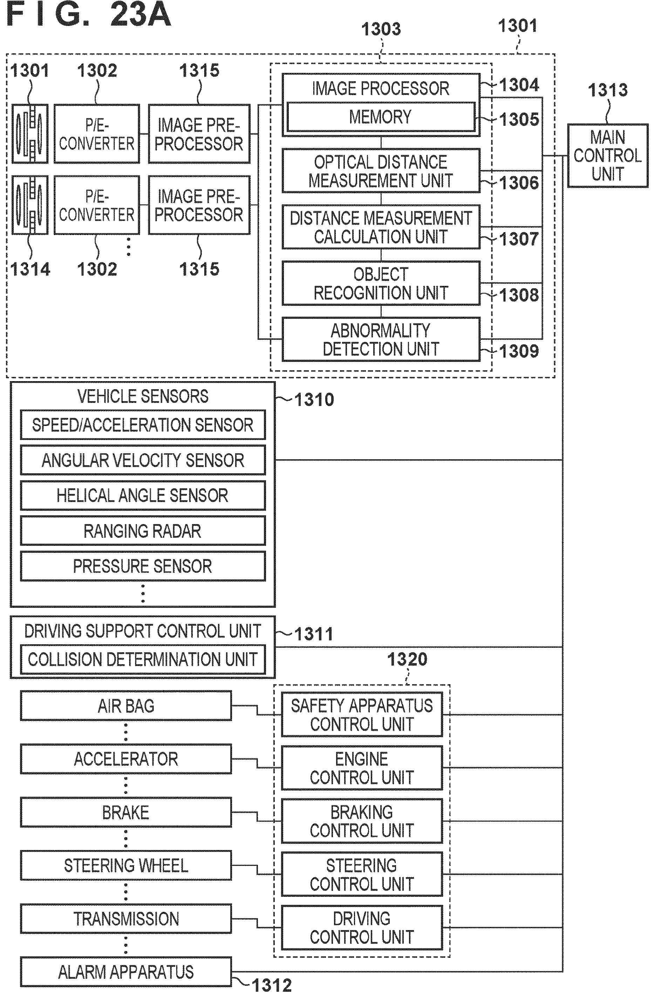

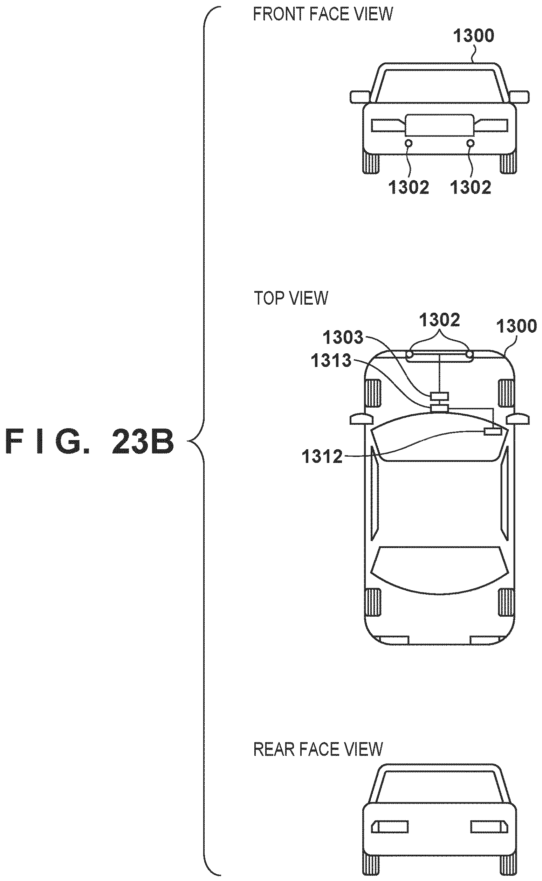

A photoelectric conversion system and a mobile object according to another embodiment will be described with reference to Figs. 23A and 23B. Figs. 23A and 23B are schematic views showing an arrangement example of the photoelectric conversion system or an arrangement example of the mobile object, respectively, according to embodiment. In embodiment, an example of an in-vehicle camera will be described as the photoelectric conversion system.

Figs. 23A and 23B show examples of a vehicle system and a photoelectric conversion system that is incorporated in the vehicle system and performs image capturing. A photoelectric conversion system 1301 includes a photoelectric conversion device 1302, an image preprocessor 1315, an integrated circuit 1303, and an optical system 1314. The optical system 1314 forms an optical image of an object on the photoelectric conversion device 1302. The photoelectric conversion device 1302 converts, into an electrical signal, the optical image of the object formed by the optical system 1314. The photoelectric conversion device 1302 can be the photoelectric conversion device described above. The image preprocessor 1315 performs predetermined signal processing for the signal output from the photoelectric conversion device 1302. The function of the image preprocessor 1315 may be incorporated in the photoelectric conversion device 1302. In the photoelectric conversion system 1301, at least two sets of the optical systems 1314, the photoelectric conversion devices 1302, and the image preprocessors 1315 are arranged, and an output from the image preprocessor 1315 of each set is input to the integrated circuit 1303.

The integrated circuit 1303 is an image capturing system application specific integrated circuit, and includes an image processor 1304 with a memory 1305, an optical distance measurement unit 1306, a distance measurement calculation unit 1307, an object recognition unit 1308, and an abnormality detection unit 1309. The image processor 1304 performs image processing such as development processing and defect correction for the output signal from each image preprocessor 1315. The memory 1305 temporarily stores a captured image, and stores the position of a defect in the captured image. The optical distance measurement unit 1306 performs focusing or distance measurement of an object. The distance measurement calculation unit 1307 calculates distance measurement information from a plurality of image data acquired by the plurality of photoelectric conversion devices 1302. The object recognition unit 1308 recognizes objects such as a vehicle, a road, a road sign, and a person. Upon detecting an abnormality of the photoelectric conversion device 1302, the abnormality detection unit 1309 notifies a main control unit 1313 of the abnormality.

The integrated circuit 1303 may be implemented by dedicated hardware, a software module, or a combination thereof. Alternatively, the integrated circuit 1303 may be implemented by a Field Programmable Gate Array (FPGA), an Application Specific Integrated Circuit (ASIC), or a combination thereof.

The main control unit 1313 comprehensively controls the operations of the photoelectric conversion system 1301, vehicle sensors 1310, a control unit 1320, and the like. A method in which the photoelectric conversion system 1301, the vehicle sensors 1310, and the control unit 1320 each individually include a communication interface and transmit/receive control signals via a communication network (for example, CAN standards) may be adopted without providing the main control unit 1313.

The integrated circuit 1303 has a function of transmitting a control signal or a setting value to each photoelectric conversion device 1302 by receiving the control signal from the main control unit 1313 or by its own control unit.

The photoelectric conversion system 1301 is connected to the vehicle sensors 1310 and can detect the traveling state of the self-vehicle such as the vehicle speed, the yaw rate, and the steering angle, the external environment of the self-vehicle, and the states of other vehicles and obstacles. The vehicle sensors 1310 also serve as a distance information acquisition unit that acquires distance information to a target object. Furthermore, the photoelectric conversion system 1301 is connected to a driving support control unit 1311 that performs various driving support operations such as automatic steering, adaptive cruise control, and anti-collision function. More specifically, with respect to a collision determination function, based on the detection results from the photoelectric conversion system 1301 and the vehicle sensors 1310, a collision with another vehicle or an obstacle is estimated or the presence/absence of a collision is determined. This performs control to avoid a collision when the collision is estimated or activates a safety apparatus at the time of a collision.

Furthermore, the photoelectric conversion system 1301 is also connected to an alarm device 1312 that generates an alarm to the driver based on the determination result of a collision determination unit. For example, if the determination result of the collision determination unit indicates that the possibility of a collision is high, the main control unit 1313 performs vehicle control to avoid a collision or reduce damage by braking, releasing the accelerator pedal, or suppressing the engine output. The alarm device 1312 sounds an alarm such as a sound, displays alarm information on the screen of a display unit such as a car navigation system or a meter panel, applies a vibration to the seat belt or a steering wheel, thereby giving an alarm to the user.

According to disclosure, it is possible to provide a technique advantageous in reducing the circuit size of a continuous-time $\Delta\Sigma$ AD conversion circuit.

Various embodiments have been described in detail above but it will be understood that the present disclosure is not limited to these embodiments and encompasses all modifications, variants, alternatives and equivalents falling within the scope of the appended claims.

**Claims**

1. An AD conversion circuit (1) that converts an analog signal provided to an input terminal (IN) into a digital signal, **characterized by** comprising:

   a continuous-time $\Delta\Sigma$ AD converter (10) including an integration circuit configured to integrate a difference signal;
   a switching circuit (30) configured to perform switching to supply an analog signal supplied to the input terminal (IN) to the continuous-time $\Delta\Sigma$ AD converter (10) in a first period and to supply a voltage signal corresponding to a voltage output from the integration circuit at an end of the first period in a second period after the first period; and
   a holding circuit configured to hold the voltage signal corresponding to the voltage output from the integration circuit at the end of the first period and provide the voltage signal to the continuous-time $\Delta\Sigma$ AD converter via the switching circuit in the second period,
   wherein the continuous-time $\Delta\Sigma$ AD converter (10) is configured to be able to perform gain adjustment for an analog signal input to the continuous-time $\Delta\Sigma$ AD converter (10).

2. The AD conversion circuit according to claim 1, **characterized in that** the analog signal input to the continuous-time $\Delta\Sigma$ AD converter in the first period undergoes gain adjustment.

3. The AD conversion circuit according to claim 1 or 2, **characterized in that** the analog signal input to the continuous-time ΔΣ AD converter in the first period is amplified.

4. The AD conversion circuit according to any one of claims 1 to 3, **characterized in that** the analog signal input to the continuous-time ΔΣ AD converter in the second period does not undergo gain adjustment.

5. The AD conversion circuit according to any one of claims 1 to 4, **characterized by** further comprising a buffer circuit configured to buffer an output from the switching circuit and supply the output to the continuous-time ΔΣ AD converter.

6. The AD conversion circuit according to any one of claims 1 to 5, **characterized in that** the integration circuit includes a first integrator and a second integrator connected to an output of the first integrator,

   the continuous-time ΔΣ AD converter further includes a comparator configured to compare an output from the second integrator with a reference signal and a DA converter connected to an output of the comparator, and the first integrator includes a variable resistor connected to an output of the switching circuit, an amplification circuit connected to an output of the variable resistor, and a resistor provided between a node between the variable resistor and the amplification circuit and an output of the DA converter.

7. The AD conversion circuit according to any one of claims 1 to 5, **characterized in that** the integration circuit includes a first integrator and a second integrator connected to an output of the first integrator,

   the continuous-time ΔΣ AD converter further includes a comparator configured to compare an output from the second integrator with a reference signal and a DA converter connected to an output of the comparator, and the first integrator is a Gm-C integrator including a transconductor and a variable capacitor, and an output of the DA converter is connected to an output of the transconductor.

8. The AD conversion circuit according to claim 6 or 7, **characterized in that** the comparator is configured to compare an output from the first integrator, an output from the second integrator, and an analog signal supplied to the first integrator with the reference signal.

9. The AD conversion circuit according to claim 6 or 7, **characterized by** further comprising a first variable amplification circuit configured to amplify an analog signal input from the input terminal to the switching circuit, wherein the comparator is configured to compare an output from the first integrator, an output from the second integrator, and an output from the first variable amplification circuit with the reference signal.

10. The AD conversion circuit according to claim 9, **characterized in that** the first variable amplification circuit is configured to amplify an analog signal input to the switching circuit in a period in which an analog signal input to the continuous-time ΔΣ AD converter undergoes gain adjustment and includes a variable resistor, and an amplifier and a resistor which are connected to an output of the variable resistor and arranged in parallel with each other.

11. The AD conversion circuit according to claim 6 or 7, **characterized by** further comprising:

    a first variable amplification circuit configured to amplify an analog signal input from the input terminal to the switching circuit; and
    a switching circuit different from the switching circuit and configured to supply an output from the first variable amplification circuit and an analog signal input to the first integrator to the comparator upon switching between the output and the analog signal,
    wherein the comparator is configured to compare an output from the first integrator, an output from the second integrator, and an output from another switching circuit with the reference signal, and
    the switching circuit is configured to supply an output from the first variable amplification circuit to the comparator in a period in which an analog signal input to the continuous-time ΔΣ AD converter undergoes gain adjustment and is configured to supply an analog signal input to the first integrator to the comparator in a period in which an analog signal input to the continuous-time ΔΣ AD converter does not undergo gain adjustment.

12. The AD conversion circuit according to any one of claims 1 to 11, **characterized by** further comprising a second variable amplification circuit between the input terminal and the switching circuit.

13. A photoelectric conversion device **characterized by** comprising:

a photoelectric conversion unit; and
the AD conversion circuit according to any one of claims 1 to 12 and configured to convert an analog signal output from the photoelectric conversion unit into a digital signal.

14. An image capturing device **characterized by** comprising:

the photoelectric conversion device according to claim 13; and
a signal processor configured to process a signal output from the photoelectric conversion device.

15. A mobile object **characterized by** comprising the image capturing device according to claim 14.

# F I G. 1

SWITCHING SIGNAL

HOLDING CIRCUIT
RESET SIGNAL
SAMPLE SIGNAL

RESET SIGNAL

DIGITAL SIGNAL

OUT

RECONSTRUCTION
CIRCUIT

950

DIGITAL
DEMODULATION
CIRCUIT

940

VOLTAGE
HOLDING
CIRCUIT

920

CONTINUOUS-TIME
ΔΣ ADC

910

SWITCHING
CIRCUIT

930

ANALOG
SIGNAL

SWITCHING
IN CIRCUIT

1

# F I G. 2

# F I G. 3

GAIN ADJUSTMENT SIGNAL

SWITCHING SIGNAL

RESET SIGNAL

ΔΣ MODULATED SIGNAL

HOLDING CIRCUIT RESET SIGNAL

SAMPLE SIGNAL

50 — GAIN CONTROL CIRCUIT

10 — CONTINUOUS-TIME ΔΣ ADC

RESIDUAL VOLTAGE

20 — BUFFER CIRCUIT

30 — IN SWITCHING CIRCUIT

ANALOG SIGNAL

1

# FIG. 4

EP 4 708 698 A1

# F I G. 5

GAIN ADJUSTMENT
SIGNAL

50

1× GAIN

520 | MULTIPLEXER | ← SWITCHING
SIGNAL

SET GAIN

# F I G. 6

SET GAIN

**10**

RESET SIGNAL

**110**

**116**

**114**

**115**

**113**

INPUT
SIGNAL

**112**

**111**

FIRST INTEGRATOR

**120**

SECOND
INTEGRATOR

**130**

ΔΣ MODULATED
SIGNAL

**140**

CONTINUOUS-TIME ΔΣ ADC HAVING GAIN ADJUSTMENT FUNCTION

RESIDUAL VOLTAGE

EP 4 708 698 A1

# F I G. 7

310

1405

INPUT SIGNAL

1404

RESET SIGNAL

OUTPUT SIGNAL

1402

1401

1403

# FIG. 8

CONTINUOUS-TIME ΔΣ ADC HAVING GAIN ADJUSTMENT FUNCTION

EP 4 708 698 A1

# F I G. 9

**GAIN CONTROL CIRCUIT** — 50

GAIN ADJUSTMENT SIGNAL

SWITCHING SIGNAL

AUTO-ZERO SIGNAL

RESET SIGNAL

10 — **CONTINUOUS-TIME ΔΣ ADC**

20

30 — SWITCHING CIRCUIT

ANALOG SIGNAL IN — **VARIABLE AMPLIFICATION CIRCUIT** — 40

**BUFFER CIRCUIT**

ΔΣ MODULATED SIGNAL

RESIDUAL VOLTAGE

HOLDING CIRCUIT RESET SIGNAL

SAMPLE SIGNAL

1

EP 4 708 698 A1

# F I G. 10

EP 4 708 698 A1

ANALOG INPUT SIGNAL

t1  t2    t3  t4  t5

AUTO-ZERO SIGNAL

RESET SIGNAL

SWITCHING SIGNAL

HOLDING CIRCUIT RESET SIGNAL

SAMPLE SIGNAL

ΔΣ ADC STATE — RESET | LOWER BIT A/D CONVERSION (-1) | RESET | UPPER BIT A/D CONVERSION (0) | RESET | LOWER BIT A/D CONVERSION (0) | RESET | UPPER BIT A/D CONVERSION (1) | RESET | LOWER BIT A/D CONVERSION (1) | RESET | UPPER BIT A/D CONVERSION (2)

RESIDUAL VOLTAGE HOLDING CIRCUIT STATE — HOLD UPPER BIT ADC RESIDUAL VOLTAGE (-1) | RESET | SAMPLE RESIDUAL VOLTAGE (0) | HOLD UPPER BIT ADC RESIDUAL VOLTAGE (0) | RESET | SAMPLE RESIDUAL VOLTAGE (1) | HOLD UPPER BIT ADC RESIDUAL VOLTAGE (1) | RESET | SAMPLE RESIDUAL VOLTAGE (2)

VARIABLE GAIN AMPLIFICATION CIRCUIT SET GAIN — FIRST SET GAIN

ΔΣ ADC SET GAIN — 1× GAIN | SECOND SET GAIN | 1× GAIN | SECOND SET GAIN | 1× GAIN | SECOND SET GAIN

DIGITAL DEMODULATION CIRCUIT STATE — RESET | LOWER BIT DEMODULATION PROCESSING (-1) | RESET | UPPER BIT DEMODULATION PROCESSING (0) | RESET | LOWER BIT DEMODULATION PROCESSING (0) | RESET | UPPER BIT DEMODULATION PROCESSING (1) | RESET | LOWER BIT DEMODULATION PROCESSING (1) | RESET | UPPER BIT DEMODULATION PROCESSING (2)

RECONSTRUCTION CIRCUIT OUTPUT — FINAL ADC RESULT (-1) | FINAL ADC RESULT (0) | FINAL ADC RESULT (1)

# F I G. 11

GAIN ADJUSTMENT SIGNAL

**510**

GAIN SEPARATION CIRCUIT

**520**

1× GAIN

MULTIPLEXER

SWITCHING
SIGNAL

FIRST
SET GAIN

SECOND
SET GAIN

# FIG. 12

50 — GAIN CONTROL CIRCUIT

GAIN ADJUSTMENT SIGNAL

SWITCHING SIGNAL

AUTO-ZERO SIGNAL

40

430

420

10 — CONTINUOUS-TIME ΔΣ ADC

RESET SIGNAL

ANALOG SIGNAL IN

440

410

VARIABLE GAIN AMPLIFICATION CIRCUIT

30

SWITCHING CIRCUIT

20

210

ΔΣ MODULATED SIGNAL

220

VOLTAGE HOLDING CIRCUIT

RESIDUAL VOLTAGE

HOLDING CIRCUIT RESET SIGNAL

SAMPLE SIGNAL

BUFFER CIRCUIT

EP 4 708 698 A1

# F I G. 13

F I G. 14

# F I G. 15

SECOND SET GAIN

165

60

166

161

ADC INTERNAL AMPLITUDE ADJUSTMENT
VARIABLE GAIN AMPLIFICATION CIRCUIT

# F I G. 16

GAIN ADJUSTMENT SIGNAL

**510**

GAIN SEPARATION CIRCUIT

1× GAIN

MULTIPLEXER — SWITCHING SIGNAL

**520**

FIRST
SET GAIN

THIRD
SET GAIN

SECOND
SET GAIN

# F I G. 17

SECOND SET GAIN

SWITCHING SIGNAL

10

AMPLIFIED SIGNAL

SWITCHING CIRCUIT ~160

RESET SIGNAL

114

115

113

120

150

ANALOG SIGNAL

112

111

SECOND INTEGRATOR

ΔΣ MODULATED SIGNAL

~110

140

FIRST INTEGRATOR

RESIDUAL VOLTAGE

CONTINUOUS-TIME ΔΣ ADC HAVING GAIN ADJUSTMENT FUNCTION

EP 4 708 698 A1

32

# F I G. 18

ANALOG INPUT SIGNAL

AUTO-ZERO SIGNAL

SECOND AUTO-ZERO SIGNAL

RESET SIGNAL

SWITCHING SIGNAL

t1 t2    t3 t4    t5

EP 4 708 698 A1

# F I G. 19

THIRD SET GAIN

SECOND AUTO-ZERO SIGNAL

60

163

164

162

161

ADC INTERNAL AMPLITUDE
ADJUSTMENT VARIABLE GAIN
AMPLIFICATION CIRCUIT

F I G. 20

# F I G. 21

EP 4 708 698 A1

# F I G. 22

EP 4 708 698 A1

# F I G. 23A

FRONT FACE VIEW

1300

1302    1302

TOP VIEW

1303
1313
1302    1300

1312

F I G.  23B

REAR FACE VIEW

Europäisches
Patentamt

European
Patent Office

Office européen
des brevets

# EUROPEAN SEARCH REPORT

**Application Number**

EP 25 20 0433

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TAN ZHICHAO ET AL: "Incremental Delta-Sigma ADCs: A Tutorial Review", IEEE TRANSACTIONS ON CIRCUITS AND SYSTEMS I: REGULAR PAPERS, IEEE, US, vol. 67, no. 12, 1 December 2020 (2020-12-01), pages 4161-4173, XP011823617, ISSN: 1549-8328, DOI: 10.1109/TCSI.2020.3033458 [retrieved on 2020-12-01] * figures 1-18 * * page 4161 - page 4170 * ----- | 1-15 | INV. H03M1/12 H03M3/00 |
| A | ZHANG YI ET AL: "A 16 b Multi-Step Incremental Analog-to-Digital Converter With Single-Opamp Multi-Slope Extended Counting", IEEE JOURNAL OF SOLID-STATE CIRCUITS, IEEE, USA, vol. 52, no. 4, 1 April 2017 (2017-04-01), pages 1066-1076, XP011644071, ISSN: 0018-9200, DOI: 10.1109/JSSC.2016.2641466 [retrieved on 2017-03-29] * figures 1-17 * * page 1066 - page 1075 * ----- -/-- | 1-15 | TECHNICAL FIELDS SEARCHED (IPC) H03M |

The present search report has been drawn up for all claims

| Place of search | Date of completion of the search | Examiner |
|---|---|---|
| The Hague | 15 January 2026 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 25 20 0433

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HUANG JIA-SHENG ET AL: "A Multistep Multistage Fifth-Order Incremental Delta Sigma Analog-to-Digital Converter for Sensor Interfaces", IEEE JOURNAL OF SOLID-STATE CIRCUITS, IEEE, USA, vol. 58, no. 10, 1 October 2023 (2023-10-01), pages 2733-2744, XP011950006, ISSN: 0018-9200, DOI: 10.1109/JSSC.2023.3288198 [retrieved on 2023-07-03] * figures 1-13 * * page 2733 - page 2743 * | 1-15 | |
| A | TAO SHA ET AL: "A Power-Efficient Continuous-Time Incremental Sigma-Delta ADC for Neural Recording Systems", IEEE TRANSACTIONS ON CIRCUITS AND SYSTEMS I: REGULAR PAPERS, IEEE, US, vol. 62, no. 6, 1 June 2015 (2015-06-01), pages 1489-1498, XP011582932, ISSN: 1549-8328, DOI: 10.1109/TCSI.2015.2418892 [retrieved on 2015-05-25] * figures 1-12 * * page 1489- - page 1497 * | 1-15 | **TECHNICAL FIELDS SEARCHED (IPC)** |

The present search report has been drawn up for all claims

| Place of search | Date of completion of the search | Examiner |
|---|---|---|
| The Hague | 15 January 2026 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2013090234 A

**Non-patent literature cited in the description**

• **TAO**. A Power-Efficient Continuous-Time Incremental Sigma-Delta ADC for Neural Recording Systems. *IEEE Transactions on Circuits and Systems I: Regular Papers*, 06 June 2015, vol. 62